(19) **Europäisches Patentamt / European Patent Office / Office européen des brevets**

(11) **EP 4 429 059 A1**

(12) **EUROPEAN PATENT APPLICATION**

(43) Date of publication:
**11.09.2024 Bulletin 2024/37**

(21) Application number: **23160075.0**

(22) Date of filing: **04.03.2023**

(51) International Patent Classification (IPC):
**H02J 3/24** *(2006.01)* **G01R 19/25** *(2006.01)*
**G01R 21/133** *(2006.01)* **G06Q 50/06** *(2024.01)*

(52) Cooperative Patent Classification (CPC):
**H02J 3/241; G01R 19/2513; G06Q 50/06;**
H02J 2203/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Hitachi Energy Ltd**
**8050 Zürich (CH)**

(72) Inventors:
• **Shchetinin, Dmitry**
**5600 Lenzburg (CH)**
• **Yuan, Kai**
**85591 Vaterstetten (DE)**
• **Larsson, Mats**
**5102 Rupperswil (CH)**

(74) Representative: **Meier, Florian**
**meier ip**
**Buschingstraße 65 (6. OG)**
**81677 München (DE)**

(54) **PROCESSING METHOD AND PROCESSING SYSTEM FOR PROCESSING MEASUREMENTS ACQUIRED IN A POWER GRID, AND SYSTEM COMPRISING A POWER GRID**

(57)     Processing methods and processing systems are provided which are operative for processing measurements acquired in a power grid (11). The processing system (20) is operative to receive data comprising frequency data, wherein the frequency data represent a grid frequency measured at one or several locations in the power grid (11) in response to a disturbance. The processing system (20) is operative to determine, for at least a part of the power grid (11), at least one response parameter that affects a grid frequency response of at least the part of the power grid (11) to a further disturbance, wherein the at least one response parameter is determined based on changes in power in response to the disturbance.

EP 4 429 059 A1

FIG. 2

**Description**

TECHNICAL FIELD

Embodiments of the invention relate to systems and methods operative to process measurements acquired in a power grid. Embodiments of the invention relate in particular to such processing systems and methods which are operative to determine characteristics of grid frequency changes in response to a disturbance.

BACKGROUND

Power grids are important infrastructure components. Most installed power grids are set up as alternating current (AC) grids having a grid frequency. The grid frequency may vary from one grid to another but is typically set to have a defined value for any region of deployment.

Disturbances may cause changes in grid frequency. Such changes in grid frequency can be problematic and can affect stability, efficiency, and safety of the power grid. Such disturbances may be caused by, e.g., disconnection of major generators or tie-lines to other network areas, or load rejection.

After a disturbance that shifts the balance between mechanical and electric energy in the power grid, the grid frequency shows an initial excursion from its nominal value and then often recovers close to its nominal value through a combination of automatic control action and active redispatch of the remaining generation. The dynamics of this change in grid frequency as a function of time is relevant, and it is desired to reduce the change in grid frequency as much as possible. The severity of a given disturbance on grid frequency, and consequently the additional risk to power system operation, can be quantified by parameters such as the rate of change of frequency (RoCoF) or nadir of the grid frequency. The grid response to a disturbance depends on a balance between electric and mechanical power, the latter being typically stored in rotating components of, e.g., generators or, where applicable, flywheel storage systems.

US 10 218 181 B2, US 10 997 674 B2, and US 11 112 438 B2 disclose exemplary techniques that allow a grid frequency response to be examined. The techniques use the active introduction of power into the grid in a known pattern and assess the response. There is still a need for even more versatile techniques of determining a grid frequency response parameter, such as techniques that can be implemented even when phasor measurement unit (PMU) instrumentation may lack PMUs in various relevant parts of the power grid, and/or that allow a grid frequency response parameter to be determined with enhanced accuracy.

SUMMARY

It is an object of the invention to provide methods, devices, and/or systems that provide enhanced techniques of determining a grid frequency response parameter that affects a change in grid frequency to disturbances. It is in particular an object of the invention to provide methods, devices, and/or systems that address one or more of the above-described needs. It is an optional object of the invention to provide methods, devices, and/or systems that can be implemented even when phasor measurement unit (PMU) instrumentation may lack PMUs in at least parts of the power grid, and/or that allow a grid frequency response parameter to be determined with enhanced accuracy.

According to exemplary embodiments, methods and systems as recited in the claims are provided.

According to an aspect of the invention, there is provided a method of processing measurements acquired in a power grid. The method comprises receiving data comprising frequency data. The frequency data represent a grid frequency measured at one or several locations in the power grid in response to a disturbance. The method comprises processing the received data to determine, for at least a part of the power grid, at least one response parameter that affects a grid frequency response of at least the part of the power grid to a further disturbance. The at least one response parameter is determined based on changes in power in response to the disturbance.

Various effects and advantages are attained by this method. The method is versatile in the sense that it is operative to determine grid frequency response parameters both when the disturbance is actively introduced for determine the grid frequency response parameter (active approach) and when the disturbance is caused by a load, a generator, or another device consuming or producing electric power that is connected to or comprised by the power grid (passive approach). By determining the at least one response parameter based on changes in power in response to the disturbance, changes in load and/or loss power caused by the disturbance can be taken into consideration, making the determination of the response parameter more accurate. By determining the at least one response parameter based on changes in power in response to the disturbance, the method can be used even in cases in which changes in load and/or loss power caused by the disturbance cannot be directly measured by a respective PMU.

As used herein, "changes in power in response to the disturbance" comprise changes that are caused by the disturbance power and that are different from the introduced disturbance power. Examples for such changes in power in response to the disturbance are changes in load power, changes in loss power, and/or changes in tie-voltage power that are caused by the disturbance but which are different from the disturbance power of the disturbance itself.

The method may be performed by or using a processing system. Thereby, the response parameter or several response parameters can be determined automatically or semi-automatically.

The method may be a method of processing the measurements for determining an inertia and/or response parameters that affect the change in frequency of the power grid to the further disturbance.

Thereby, response parameters can be determined which are particularly useful for improving frequency stability and/or for assessing the effect of the further disturbance on the grid frequency before the further disturbance takes place.

The response parameter may comprise at least an inertia of a generator equivalent model, such as an inertia of a single generator equivalent model of the power grid or a portion thereof.

Thereby, a response parameter can be determined which is particularly useful for determining the changes in grid frequency based on, e.g., a power swing equation.

The response parameter may comprise a parameter that depends on the balance between mechanical and electric power in the power grid (such as an inertia of a generator equivalent model).

Thereby, a response parameter can be determined which is particularly useful for determining the changes in grid frequency that are caused by a shift of the balance between mechanical and electric power in the power grid.

The changes in power may comprise a total power deviation. The total power deviation may comprise the disturbance power and a change in power that is a response to the disturbance in at least a part of the power grid.

By taking into consideration the total power deviation, which includes both the disturbance power itself and power changes that are a reaction to the disturbance, the response parameter (such as an inertia of a single generator equivalent model) may be determined more accurately as compared to techniques which only take into account the disturbance power itself.

The total power deviation may comprise a power of the disturbance and a change of load power and/or loss power caused by the disturbance.

By taking into consideration the change of load power and/or loss power caused by the disturbance, the response parameter (such as an inertia of a single generator equivalent model) may be determined more accurately as compared to techniques which only take into account the disturbance power itself.

Processing the received data may comprise determining the change of load power and/or loss power caused by the disturbance. Determining the change of load power and/or loss power caused by the disturbance may comprise computing the change of load power and/or loss power from PMU measurements included in the received data.

Thereby, the change of load power and/or loss power caused by the disturbance may be determined efficiently. The accuracy with which the at least one response parameter is determined is enhanced.

Alternatively or additionally, determining the change of load power and/or loss power caused by the disturbance may comprise computing the change of load power and/or loss power from voltage measurements included in the received data.

Thereby, the change of load power and/or loss power caused by the disturbance may be determined even when PMU measurements are not available. The accuracy with which the at least one response parameter is determined is enhanced.

Computing the change of load power and/or loss power from voltage measurements may comprise determining a proportionality constant between a change in voltage as obtained from the voltage measurements and the change in load power.

Thereby, the change of load power caused by the disturbance may be determined efficiently even when no PMU measurement is available. The accuracy with which the at least one response parameter is determined is enhanced by taking into consideration the thus determined change of load power caused by the disturbance.

Determining the proportionality constant between the change in voltage and the change in load power may comprise identifying the proportionality constant from among a set of proportionality constants that minimizes a metric quantifying a time-dependent deviation of the measured change in grid frequency as a function of time from a computationally determined change in grid frequency as a function of time, with the computationally determined change in grid frequency being obtained for a linear dependence of change of load power from the voltage measurement.

Thereby, the change of load power caused by the disturbance may be determined efficiently even when no PMU measurement is available. The accuracy with which the at least one response parameter is determined is enhanced by taking into consideration the thus determined change of load power caused by the disturbance.

Alternatively or additionally, processing the received data may comprise determining the change of load power and/or loss power based on a state estimation.

Thereby, the change of load power and/or loss power caused by the disturbance may be determined and taken into consideration when determining the at least one response parameter. The accuracy with which the at least one response parameter is determined is enhanced by taking into consideration the thus determined change of load power and/or loss power caused by the disturbance.

Processing the received data may comprise determining the changes in power in a time-dependent manner.

Thereby, time-dependent changes in grid frequency may be combined with time-dependent changes in power (e.g., changes in the aggregate of disturbance power, loss power, and load power). More accurate determination of the at least one response parameter (e.g., parameters of a single generator equivalent such as inertia) is possible.

Processing the received data may comprise processing both the time-dependent changes in power and time-dependent changes in grid frequency as indicated by the measurements.

Thereby, time-dependent changes in grid frequency may be combined with time-dependent changes in power (e.g., changes in the aggregate of disturbance power, loss power, and load power). More accurate determination of the at least one response parameter (e.g., parameters of a single generator equivalent such as inertia) is possible.

The changes in power may be determined as time-series data or as non-regularly recurring data. The changes in frequency may be time-series data or non-regularly recurring data.

Thereby, the at least one response parameter can be determined efficiently taking into consideration the dynamics of power changes (e.g., changes in the sum of disturbance power, load power, and loss power) and the concurrent dynamics of the grid frequency change as a function of time.

The method may comprise obtaining a disturbance magnitude and disturbance time information. The at least one response parameter may be determined further based on the disturbance magnitude (e.g., disturbance power) and disturbance time information (e.g., incipient time or an estimate for the incipient time).

This allows the at least one response parameter to be determined based on the power grid response to the known characteristics of the disturbance.

Different processing may be used depending on whether the disturbance is a disturbance that is actively introduced into the grid for the purpose (e.g., the sole purpose) of determining the at least one response parameter (active approach of determining the at least one response parameter) or whether the disturbance is caused by, e.g., one of the loads (such as an arc furnace) or generators (passive approach of determining the at least one response parameter).

For the active approach, the disturbance magnitude and disturbance time information (e.g., incipient time and/or time dependence of the disturbance power) may be determined by the processing system before the disturbance is introduced into the power grid. It may be not required (while still possible) to also rely on measurements for determining the disturbance power. Measurements are used for determining the change in load and/or loss power caused by the disturbance.

For the passive approach, the disturbance magnitude and disturbance time information may be determined (e.g., estimated) by processing measurements included in the received data.

The processing system may be capable of operating both according to the active approach and according to the passive approach. The processing system may switch its operating mode depending on whether the at least one response parameter is determined according to the active approach or according to the passive approach.

The time information may comprise an incipient time of the disturbance or a time series of at least one electric characteristic caused by the disturbance.

Thereby, changes in load and/or loss power may be correlated with the time at which the disturbance occurred, to assist identifying changes in load and/or loss power caused by the disturbance.

The received data may comprise outputs of measurement instrumentation, wherein the measurement instrumentation is coupled to the power grid. The measurement instrumentation may comprise PMUs. The measurement instrumentation may comprise voltage measurement instrumentation. The measurement instrumentation may comprise measurement instrumentation capable of measuring grid frequency at one or several locations of the power grid.

Thereby, the measurements required for determining inertia or other response parameters that determine the change in grid frequency caused by the further disturbance are obtained, without necessarily requiring (while still allowing) full PMU observability.

The method may further comprise causing the disturbance to be introduced into the power grid.

Thereby, the disturbance can be actively introduced for the purpose (e.g., for the sole purpose) of determining the at least one response parameter.

The method may further comprise setting a disturbance frequency of the disturbance based on electric and/or mechanical resonances of the power grid.

Thereby, undesired resonance excitations can be avoided. The at least one grid parameter may be determined more accurately.

The disturbance frequency may be set to prevent excitation of the electric and/or mechanical resonances of the power grid.

Thereby, undesired resonance excitations can be avoided. The at least one grid parameter may be determined more accurately,

Causing the disturbance to be introduced into the power grid may comprise controlling at least one apparatus comprised by or coupled to the power grid to introduce the disturbance and reduce an impact of the disturbance on voltage magnitudes in the power grid.

Thereby, undesired changes in voltage magnitude can be reduced, thereby mitigating potentially negative effects on the loads connected to the power grid while allowing the at least one grid parameter to be determined more accurately.

The at least one apparatus controlled by the processing system may comprise an apparatus operative to affect reactive power in the power grid.

Thereby, undesired changes in voltage magnitude can be reduced, thereby mitigating potentially negative effects on the loads connected to the power grid while allowing the at least one grid parameter to be determined more accurately.

Causing the disturbance to be introduced into the power grid may comprise controlling at least a first apparatus comprised by or coupled to the power grid to introduce the disturbance and controlling at least a second apparatus comprised by or coupled to the power grid to reduce an impact of the disturbance on voltage magnitudes in the power grid. The at least one second apparatus may comprise an apparatus operative to affect reactive power in the power grid, such as a reactance.

The at least one response parameter may comprise a parameter of a generator equivalent model. The at least one response parameter may comprise a parameter of a single generator equivalent model of generators of the power grid or of part of the power grid. The determined at least one response parameter may comprise one, several, or all of: inertia, damping, governor time constant, governor gain, load sensitivity to voltage magnitude.

Thereby, one or several response parameters may be determined that are useful for assessing and potentially mitigating future changes in grid frequency in response to the further disturbance.

Determining the at least one response parameter may comprise determining parameters of a time-discrete response function. The time-discrete response function may establish a relationship between the change in grid frequency in a time interval after an incipient time of the disturbance (which change in grid frequency is time-dependent) to the change in the total power defined as the sum of disturbance power, load power, and loss power in the time interval after the incipient time (which change in the total power is also time-dependent).

Determining the at least one response parameter may comprise determining parameters of a power swing equation, which relates the change in grid frequency in a time interval after an incipient time of the disturbance (which change in grid frequency is time-dependent) to the change in the total power defined as the sum of disturbance power, load power, and loss power in the time interval after the incipient time (which change in the total power is also time-dependent).

Thereby, the at least one response parameter may be determined efficiently, using, e.g., linear response theory.

The method may further comprise repeating the steps of receiving data and processing the received data for two or more areas of the power grid to determine the at least one response parameter for each of the two or more areas.

Thereby, the inertia and/or other response parameters may be determined individually for each of the two or more areas.

The method may further comprise storing the at least one response parameter in a control, monitoring, and/or protection device or system for assessing the grid frequency response to the further disturbance.

This facilitates taking appropriate action for stabilizing the grid frequency in the future and/or for providing information (such as alerts and/or warnings) in case a planned generator unit commitment has the potential of leading to unacceptable magnitudes of the grid frequency (e.g., unacceptable frequency nadir) and/or unacceptable rate of changes of the grid frequency (e.g., unacceptable rate of change of frequency (RoCoF)).

The method may further comprise using, by a processing system carrying out the method, the at least one response parameter to assess the grid frequency response to the further disturbance. The assessed grid frequency response may comprise a rate of change of frequency, RoCoF, and/or a frequency nadir.

This facilitates taking appropriate action for stabilizing the grid frequency in the future and/or for providing information (such as alerts and/or warnings) in case a planned generator unit commitment has the potential of leading to unacceptable magnitudes of the grid frequency (and/or unacceptable rate of changes of the grid frequency.

The method may further comprise effecting, by the processing system, an action based on the at least one response parameter. The action may comprise a corrective and/or mitigating action that reduces a change in grid frequency brought about by the further disturbance.

Thereby, the method contributes to maintaining the grid frequency stable.

According to another aspect of the invention, there is provided a power grid control, monitoring, and/or protection method. The power grid control, monitoring, and/or protection method comprises using, by a control, monitoring, and/or protection device or system, the at least one response parameter determined by the method of aspect or embodiment disclosed above to determine the at least one response parameter, and performing an action based on the at least one response parameter to reduce a change in grid frequency brought about by the further disturbance.

Thereby, the method contributes to maintaining grid frequency stability.

A processing system for processing measurements acquired in a power grid, the processing system comprising at least one processing circuit operative to receive data comprising frequency data, wherein the frequency data represent a grid frequency measured at one or several locations in the power grid in response to a disturbance, and process the received data to determine, for at least a part of the power grid, at least one response parameter that affects a grid frequency response of at least the part of the power grid to a further disturbance, wherein the at least one processing circuit is operative to determine the at least one response parameter based on changes in power in response to the disturbance.

Various effects and advantages are attained by this processing system. The processing system is versatile in the sense that it is operative to determine grid frequency response parameters both when the disturbance is actively introduced for determine the grid frequency response parameter (active approach) and when the disturbance is caused by a load that is connected to or comprised by the power grid (passive approach). By determining the at least one response parameter based on changes in power, the processing system can take into consideration changes in load and/or loss power caused by the disturbance, making the determination of the response parameter more accurate. By determining the at least one response parameter based on changes in power, the processing system can be used even in cases in which changes in load and/or loss power caused by the disturbance cannot be measured by a respective PMU.

The processing system may be operative for processing the measurements to determine an inertia and/or response parameters that affect the change in frequency of the power grid to the further disturbance.

Thereby, the processing system can determine response parameters which are particularly useful for improving frequency stability and/or for assessing the effect of the further disturbance on the grid frequency before the further disturbance takes place.

The processing system may be operative such that the determined response parameter comprises at least an inertia of a generator equivalent model, such as an inertia of a single generator equivalent model of the power grid or a portion thereof.

Thereby, the processing system can determine a response parameter which is particularly useful for determining the changes in grid frequency based on, e.g., a power swing equation.

The processing system may be operative such that the determined response parameter comprises a parameter that depends on the balance between mechanical and electric power in the power grid (such as an inertia of a generator equivalent model).

Thereby, the processing system can determine a response parameter which is particularly useful for determining the changes in grid frequency that are caused by a shift of the balance between mechanical and electric power in the power grid.

The changes in power may comprise a total power deviation. The total power deviation may comprise the disturbance power and a change in power that is a response to the disturbance in at least a part of the power grid.

By taking into consideration the total power deviation, which includes both the disturbance power itself and power changes that are a reaction to the disturbance, the processing system can determine the response parameter (such as an inertia of a single generator equivalent model) more accurately as compared to techniques which only take into account the disturbance power itself.

The processing system may be operative such that the total power deviation may comprise a power of the disturbance and a change of load power and/or loss power caused by the disturbance.

By taking into consideration the change of load power and/or loss power caused by the disturbance, the processing system can determine the response parameter (such as an inertia of a single generator equivalent model) more accurately as compared to techniques which only take into account the disturbance power itself.

The processing system may be operative to determine the change of load power and/or loss power caused by the disturbance based on the received data. The processing system may be operative such that determining the change of load power and/or loss power caused by the disturbance comprises computing the change of load power and/or loss power from PMU measurements included in the received data.

Thereby, the processing system may determine the change of load power and/or loss power caused by the disturbance efficiently. The accuracy with which the at least one response parameter is determined is enhanced.

Alternatively or additionally, the processing system may be operative such that determining the change of load power and/or loss power caused by the disturbance may comprise computing the change of load power and/or loss power from voltage measurements included in the received data.

Thereby, the processing system may determine the change of load power and/or loss power caused by the disturbance even when PMU measurements are not available. The accuracy with which the at least one response parameter is determined is enhanced.

The processing system may be operative such that computing the change of load power and/or loss power from voltage measurements comprises determining a proportionality constant between a change in voltage as obtained from the voltage measurements and the change in load power.

Thereby, the processing system may determine the change of load power caused by the disturbance efficiently even when no PMU measurement is available. The accuracy with which the at least one response parameter is determined is enhanced by taking into consideration the thus determined change of load power caused by the disturbance.

The processing system may be operative such that determining the proportionality constant between the change in voltage and the change in load power may comprise identifying the proportionality constant from among a set of proportionality constants that minimizes a metric quantifying a time-dependent deviation of the measured change in grid frequency as a function of time from a computationally determined change in grid frequency as a function of time, with the computationally determined change in grid frequency being obtained for a linear dependence of change of load power from the voltage measurement.

Thereby, the processing system can determine the change of load power caused by the disturbance efficiently even when no PMU measurement is available. The accuracy with which the at least one response parameter is determined is enhanced by taking into consideration the thus determined change of load power caused by the disturbance.

Alternatively or additionally, the processing system may be operative to determine the change of load power and/or loss power based on a state estimation, based on the received data.

Thereby, the processing system can determine the change of load power and/or loss power caused by the disturbance and take it into consideration when determining the at least one response parameter. The accuracy with which the at least one response parameter is determined is enhanced by taking into consideration the thus determined change of load power and/or loss power caused by the disturbance.

The processing system may be operative to determine the changes in power in a time-dependent manner.

Thereby, the processing system can combine (e.g., correlate) time-dependent changes in grid frequency with time-dependent changes in power (e.g., changes in the aggregate of disturbance power, loss power, and load power). More accurate determination of the at least one response parameter (e.g., parameters of a single generator equivalent such as inertia) is possible.

The processing system may be operative to process both the time-dependent changes in power and time-dependent changes in grid frequency as indicated by the measurements.

Thereby, the processing system can combine (e.g., correlate) time-dependent changes in grid frequency with time-dependent changes in power (e.g., changes in the aggregate of disturbance power, loss power, and load power). More accurate determination of the at least one response parameter (e.g., parameters of a single generator equivalent such as inertia) is possible.

The processing system may be operative to determine the changes in power as time-series data or as non-regularly recurring data. The processing system may be operative to determine the changes in frequency as time-series data or non-regularly recurring data.

Thereby, the processing system can determine the at least one response parameter efficiently taking into consideration the dynamics of power changes (e.g., changes in the sum of disturbance power, load power, and loss power) and the concurrent dynamics of the grid frequency change as a function of time.

The processing system may be operative to obtain a disturbance magnitude and disturbance time information. The processing system may be operative to determine the at least one response parameter further based on the disturbance magnitude (e.g., disturbance power) and disturbance time information (e.g., incipient time or an estimate for the incipient time).

This allows the processing system to determine the at least one response parameter based on the power grid response to the known characteristics of the disturbance.

The processing system may be operative to perform different processing depending on whether the disturbance is a disturbance that is actively introduced into the grid for the purpose (e.g., the sole purpose) of determining the at least one response parameter (active approach of determining the at least one response parameter) or whether the disturbance is caused by, e.g., one of the loads (such as an arc furnace) (passive approach of determining the at least one response parameter).

For the active approach, the processing system may be operative to determine the disturbance magnitude and disturbance time information (e.g., incipient time and/or time dependence of the disturbance power) before the disturbance is introduced into the power grid. It may be not required (while still possible) to also rely on measurements for determining the disturbance power. The processing system may be operative to use measurements for determining the change in load and/or loss power caused by the disturbance.

For the passive approach, the processing system may be operative to determine (e.g., estimate) the disturbance magnitude and disturbance time information by processing measurements included in the received data.

The processing system may be operative to operate both according to the active approach and according to the passive approach. The processing system may switch its operating mode depending on whether the at least one response parameter is determined according to the active approach or according to the passive approach.

The processing system may be operative such that the time information may comprise an incipient time of the disturbance or a time series of at least one electric characteristic caused by the disturbance.

Thereby, the processing system may correlate changes in load and/or loss power with the time at which the disturbance occurred, to assist identifying changes in load and/or loss power caused by the disturbance.

The processing system may be operative such that the received data comprises outputs of measurement instrumentation coupled to the power grid. The measurement instrumentation may comprise PMUs. The measurement instrumentation may comprise voltage measurement instrumentation. The measurement instrumentation may comprise measurement instrumentation capable of measuring grid frequency at one or several locations of the power grid.

Thereby, the processing system can obtain the measurements required for determining inertia or other response parameters that determine the change in grid frequency caused by the further disturbance, without necessarily requiring (while still allowing) full PMU observability.

The processing system may be operative to cause the disturbance to be introduced into the power grid.

Thereby, the processing system can actively introduce the disturbance for the purpose (e.g., for the sole purpose) of determining the at least one response parameter.

The processing system may be operative for setting a disturbance frequency of the disturbance based on electric and/or mechanical resonances of the power grid.

Thereby, undesired resonance excitations can be avoided. The at least one grid parameter may be determined more accurately,

The processing system may be operative to set the disturbance frequency to prevent excitation of the electric and/or mechanical resonances of the power grid.

Thereby, the processing system can avoid undesired resonance excitations. The at least one grid parameter may be determined more accurately,

The processing system may be operative such that, to introduce the disturbance into the power grid, the processing system is operative to control at least one apparatus comprised by or coupled to the power grid to introduce the disturbance and reduce an impact of the disturbance on voltage magnitudes in the power grid.

Thereby, undesired changes in voltage magnitude can be reduced, thereby mitigating potentially negative effects on the loads connected to the power grid while allowing the at least one grid parameter to be determined more accurately.

The at least one apparatus controlled by the processing system may comprise an apparatus operative to affect reactive power in the power grid.

Thereby, undesired changes in voltage magnitude can be reduced, thereby mitigating potentially negative effects on the loads connected to the power grid while allowing the at least one grid parameter to be determined more accurately.

The processing system may be operative such that, to cause the disturbance to be introduced into the power grid, the processing system is operative to control at least a first apparatus comprised by or coupled to the power grid to introduce the disturbance and controlling at least a second apparatus comprised by or coupled to the power grid to reduce an impact of the disturbance on voltage magnitudes in the power grid. The at least one second apparatus may comprise an apparatus operative to affect reactive power in the power grid, such as a reactance.

The processing system may be operative such that the at least one response parameter determined by the processing system comprises a parameter of a generator equivalent model. The processing system may be operative such that the at least one response parameter determined by the processing system comprises a parameter of a single generator equivalent model of generators of the power grid or of part of the power grid. The processing system may be operative such that the at least one response parameter determined by the processing system comprises one, several, or all of: inertia, damping, governor time constant, governor gain, load sensitivity to voltage magnitude.

Thereby, one or several response parameters may be determined that are useful for assessing and potentially mitigating future changes in grid frequency in response to the further disturbance.

The processing system may be operative to determine parameters of a time-discrete response function for determining the at least one response parameter. The time-discrete response function may establish a relationship between the change in grid frequency in a time interval after an incipient time of the disturbance (which change in grid frequency is time-dependent) to the change in the total power defined as the sum of disturbance power, load power, and loss power in the time interval after the incipient time (which change in the total power is also time-dependent).

The processing system may be operative such that, to determine the at least one response parameter comprises, it determines parameters of a power swing equation, which relates the change in grid frequency in a time interval after an incipient time of the disturbance (which change in grid frequency is time-dependent) to the change in the total power defined as the sum of disturbance power, load power, and loss power in the time interval after the incipient time (which change in the total power is also time-dependent).

Thereby, the at least one response parameter may be determined efficiently by the processing system, using, e.g., linear response theory.

The processing system may be operative to repeat receiving data and processing the received data for two or more areas of the power grid to determine the at least one response parameter for each of the two or more areas.

Thereby, the processing system can determine inertia and/or other response parameters individually for each of the two or more areas.

The processing system may be operative to store the at least one response parameter in a control, monitoring, and/or protection device or system for assessing the grid frequency response to the further disturbance.

This facilitates taking appropriate action for stabilizing the grid frequency in the future and/or for providing information (such as alerts and/or warnings) in case a planned generator unit commitment has the potential of leading to unacceptable magnitudes of the grid frequency (e.g., unacceptable frequency nadir) and/or unacceptable rate of changes of the grid frequency (e.g., unacceptable rate of change of frequency (RoCoF)).

The processing system may be operative to use the at least one response parameter to assess the grid frequency response to the further disturbance. The assessed grid frequency response may comprise a rate of change of frequency, RoCoF, and/or a frequency nadir.

This facilitates taking appropriate action for stabilizing the grid frequency in the future and/or for providing information (such as alerts and/or warnings) in case a planned generator unit commitment has the potential of leading to unacceptable magnitudes of the grid frequency (and/or unacceptable rate of changes of the grid frequency.

The processing system may be operative to effect an action based on the at least one response parameter. The action may comprise a corrective and/or mitigating action that reduces a change in grid frequency brought about by the further disturbance.

Thereby, the processing system contributes to maintaining the grid frequency stable.

The processing system may be operative to effect an action based on the at least one response parameter, wherein the action comprises changing a planned future generator unit commitment.

Thereby, the processing system contributes to maintaining the grid frequency stable.

The processing system may be operative to automatically or semi-automatically perform the method of any one of the aspects or embodiments disclosed herein.

According to another aspect of the invention, there is provided a system which comprises a power grid and the processing system of an aspect or embodiment disclosed herein, operative to determine the at least one response parameter.

The system may further comprise a control, monitoring, and/or protection device or system operative to perform an action in response to the further disturbance based on the at least one response parameter.

The control, monitoring, and/or protection device or system may be operative to perform the action based on the at least one response parameter so as to maintain the change in grid frequency in response to a future disturbance to less than a frequency change threshold.

The action performed by the control, monitoring, and/or protection device or system may be a change in generator unit commitment for one or several generator units.

The system may further comprise measurement instrumentation operative to provide some or all of the data to the processing system. The measurement instrumentation may comprise PMUs. The measurement instrumentation may comprise voltage measurement instrumentation.

Thereby, the at least one response parameter may be determined based on measurements, using the change in power (e.g., the aggregate of disturbance power, loss power, and load power) for determining the at least one response parameter.

According to another aspect of the invention, which may be used in combination with or independently of the above-described aspects and embodiments, there is provided a method of processing measurements acquired in a power grid. The method is performed by a processing system and comprises: causing a disturbance to be introduced into the power grid, receiving data comprising frequency data, wherein the frequency data represent a grid frequency measured at one or several locations in the power grid, and processing the received data to determine, for at least a part of the power grid, at least one response parameter that affects a grid frequency response of at least the part of the power grid to a further disturbance.

Various effects and advantages are attained by this method. The method allows the disturbance to be introduced in a controlled manner, facilitating the determination of the at least one response parameter with high accuracy.

The method may be a method of processing the measurements for determining an inertia and/or response parameters that affect the change in frequency of the power grid to the further disturbance.

Thereby, response parameters can be determined which are particularly useful for improving frequency stability and/or for assessing the effect of the further disturbance on the grid frequency before the further disturbance takes place.

The method may further comprise setting a disturbance frequency of the disturbance based on electric and/or mechanical resonances of the power grid.

Thereby, undesired resonance excitations can be avoided. The at least one grid parameter may be determined more accurately.

The disturbance frequency may be set to prevent excitation of the electric and/or mechanical resonances of the power grid, and/or the disturbance frequency is set such that the disturbance frequency is spaced from any of the electric and/or mechanical resonances of the power grid by at least a threshold.

Thereby, undesired resonance excitations can be avoided. The at least one grid parameter may be determined more accurately.

Causing the disturbance to be introduced into the power grid may comprise controlling at least one first apparatus comprised by or coupled to the power grid to introduce the disturbance.

Causing the disturbance to be introduced into the power grid may comprise controlling at least one apparatus comprised by or coupled to the power grid to introduce the disturbance and reduce an impact of the disturbance on voltage magnitudes in the power grid.

Thereby, undesired changes in voltage magnitude can be reduced, thereby mitigating potentially negative effects on the loads connected to the power grid while allowing the at least one grid parameter to be determined more accurately.

The at least one apparatus controlled by the processing system may comprise an apparatus operative to affect reactive power in the power grid.

Thereby, undesired changes in voltage magnitude can be reduced, thereby mitigating potentially negative effects on the loads connected to the power grid while allowing the at least one grid parameter to be determined more accurately.

Causing the disturbance to be introduced into the power grid may comprise controlling at least a first apparatus comprised by or coupled to the power grid to introduce the disturbance and controlling at least a second apparatus comprised by or coupled to the power grid to reduce an impact of the disturbance on voltage magnitudes in the power grid. The at least one second apparatus may comprise an apparatus operative to affect reactive power in the power grid, such as a reactance.

Processing the received data may comprise determining the at least one response parameter based on a total power deviation, wherein the total power deviation comprises a power of the introduced disturbance and changes in power in response to the introduced disturbance.

Thereby, changes in load and/or loss power caused by the disturbance can be taken into consideration, making the determination of the response parameter more accurate. By determining the at least one response parameter based on changes in power, the method can be used even in cases in which changes in load and/or loss power caused by the disturbance cannot be measured by a respective PMU.

The at least one response parameter may comprise a parameter of a generator equivalent model. The at least one response parameter may comprise a parameter of a single generator equivalent model of generators of the power grid or of part of the power grid. The determined at least one response parameter may comprise one, several, or all of: inertia, damping, governor time constant, governor gain, load sensitivity to voltage magnitude.

Thereby, one or several response parameters may be determined that are useful for assessing and potentially mitigating future changes in grid frequency in response to the further disturbance.

Determining the at least one response parameter may comprise determining parameters of a time-discrete response function. The time-discrete response function may establish a relationship between the change in grid frequency in a time interval after an incipient time of the disturbance (which change in grid frequency is time-dependent) to the change in the total power defined as the sum of disturbance power, load power, and loss power in the time interval after the incipient time (which change in the total power is also time-dependent).

Determining the at least one response parameter may comprise determining parameters of a power swing equation, which relates the change in grid frequency in a time interval after an incipient time of the disturbance (which change in grid frequency is time-dependent) to the change in the total power defined as the sum of disturbance power, load power, and loss power in the time interval after the incipient time (which change in the total power is also time-dependent).

Thereby, the at least one response parameter may be determined efficiently, using, e.g., linear response theory.

The method may further comprise repeating the steps of causing the disturbance to be introduced, receiving data, and processing the received data for two or more areas of the power grid to determine the at least one response parameter for each of the two or more areas.

Thereby, the inertia and/or other response parameters may be determined individually for each of the two or more areas.

Processing the received data may comprise determining a change of load power and/or change of loss power caused by the disturbance, optionally wherein processing the received data comprises determining the change of load power based on voltage magnitude measurements, and/or optionally wherein processing the received data comprises determining the change of loss power based on a state estimation.

The response parameter may comprise at least an inertia of a generator equivalent model, such as an inertia of a single generator equivalent model of the power grid or a portion thereof.

Thereby, a response parameter can be determined which is particularly useful for determining the changes in grid frequency based on, e.g., a power swing equation.

The response parameter may comprise a parameter that depends on the balance between mechanical and electric power in the power grid (such as an inertia of a generator equivalent model).

Thereby, a response parameter can be determined which is particularly useful for determining the changes in grid frequency that are caused by a shift of the balance between mechanical and electric power in the power grid.

The changes in power may comprise a total power deviation. The total power deviation may comprise the disturbance power and a change in power that is a response to the disturbance in at least a part of the power grid.

By taking into consideration the total power deviation, which includes both the disturbance power itself and power changes that are a reaction to the disturbance, the response parameter (such as an inertia of a single generator equivalent model) may be determined more accurately as compared to techniques which only take into account the disturbance power itself.

The total power deviation may comprise a power of the disturbance and a change of load power and/or loss power caused by the disturbance.

By taking into consideration the change of load power and/or loss power caused by the disturbance, the response parameter (such as an inertia of a single generator equivalent model) may be determined more accurately as compared to techniques which only take into account the disturbance power itself.

Processing the received data may comprise determining the change of load power and/or loss power caused by the disturbance. Determining the change of load power and/or loss power caused by the disturbance may comprise computing the change of load power and/or loss power from PMU measurements included in the received data.

Thereby, the change of load power and/or loss power caused by the disturbance may be determined efficiently. The accuracy with which the at least one response parameter is determined is enhanced.

Alternatively or additionally, determining the change of load power and/or loss power caused by the disturbance may comprise computing the change of load power and/or loss power from voltage measurements included in the received data.

Thereby, the change of load power and/or loss power caused by the disturbance may be determined even when PMU measurements are not available. The accuracy with which the at least one response parameter is determined is enhanced.

The method may further comprise storing the at least one response parameter in a control, monitoring, and/or protection device or system for assessing the grid frequency response to the further disturbance.

This facilitates taking appropriate action for stabilizing the grid frequency in the future and/or for providing information (such as alerts and/or warnings) in case a planned generator unit commitment has the potential of leading to unacceptable magnitudes of the grid frequency (e.g., unacceptable frequency nadir) and/or unacceptable rate of changes of the grid frequency (e.g., unacceptable rate of change of frequency (RoCoF)).

The method may further comprise using, by a processing system carrying out the method, the at least one response parameter to assess the grid frequency response to the further disturbance. The assessed grid frequency response may comprise a rate of change of frequency, RoCoF, and/or a frequency nadir.

This facilitates taking appropriate action for stabilizing the grid frequency in the future and/or for providing information (such as alerts and/or warnings) in case a planned generator unit commitment has the potential of leading to unacceptable magnitudes of the grid frequency (and/or unacceptable rate of changes of the grid frequency.

The method may further comprise effecting, by the processing system, an action based on the at least one response parameter. The action may comprise a corrective and/or mitigating action that reduces a change in grid frequency brought about by the further disturbance.

Thereby, the method contributes to maintaining the grid frequency stable.

A power grid control, protection, and/or monitoring method according to an embodiment comprises using, by a control, protection, and/or monitoring device or system, the at least one response parameter to assess the effect of the further disturbance on a grid frequency and performing a corrective and/or mitigating action based on the at least one response parameter determined using the method according to an aspect or embodiment disclosed above.

According to another aspect of the invention, which may be used in combination with or separately from the above-described aspects and embodiments, there is provided a processing system for processing measurements acquired in a power grid. The processing system comprises an interface; and at least one processing circuit operative to: generate and output a command via the interface to cause a disturbance to be introduced into the power grid, receive data comprising frequency data, wherein the frequency data represent a grid frequency measured at one or several locations in the power grid, and process the received data to determine, for at least a part of the power grid, at least one response parameter that affects a grid frequency response of at least the part of the power grid to a further disturbance.

Various effects and advantages are attained by this processing system. The processing system allows the disturbance to be introduced in a controlled manner, facilitating the determination of the at least one response parameter with high accuracy.

The processing system may be operative to perform the method of any one of the aspects or embodiments disclosed above.

According to another aspect of the invention, there is provided a power grid which comprises the processing system of an aspect or embodiment disclosed herein, operative to determine the at least one response parameter.

The power grid may further comprise a control, monitoring, and/or protection device or system operative to perform an action in response to the further disturbance based on the at least one response parameter

The control, monitoring, and/or protection device or system may be operative to perform the action based on the at least one response parameter so as to maintain the change in grid frequency in response to a future disturbance to less than a frequency change threshold.

The action performed by the control, monitoring, and/or protection device or system may be a change in generator unit commitment for one or several generator units.

The power grid may further comprise measurement instrumentation operative to provide some or all of the data to the processing system. The measurement instrumentation may comprise PMUs. The measurement instrumentation may comprise voltage measurement instrumentation.

Thereby, the at least one response parameter may be determined based on measurements, using the change in power (e.g., the aggregate of disturbance power, loss power, and load power) for determining the at least one response parameter.

According to further embodiments, there is provided machine-readable instruction code which, when executed by at least one programmable circuit, causes the at least one programmable circuit to perform the method according to an embodiment.

According to further embodiments, there is provided a non-transitory storage medium having stored thereon machine-readable instruction code which, when executed by at least one programmable circuit, causes the at least one programmable circuit to perform the method according to an embodiment.

Various effects and advantages are attained by embodiments of the invention. For illustration, the systems and methods according to embodiments provide enhanced techniques of determining inertia and/or one or several other response parameter(s) with high accuracy and in an efficient manner. The systems and methods are particularly useful for power grids with renewables penetration. The systems and methods allow the at least one response parameter, which determines the frequency change in response to a further disturbance, to be determined even when PMU instrumentation is not available at all required locations. The systems and methods disclosed herein are operative to replace at least some missing PMU measurements with voltage measurements in association with processing that allows power changes to be estimated from the measured voltage changes.

The systems and methods can be used in association with an electric power grid having renewable energy sources and/or battery-based or mechanical energy storage systems, without being limited thereto.

## BRIEF DESCRIPTION OF THE DRAWINGS

Embodiments of the invention will be described with reference to the drawings in which similar or identical reference signs designate elements with similar or identical configuration and/or function.

Figure 1 is a block diagram of a processing system.
Figure 2 is a block diagram of a system comprising the processing system.
Figure 3 is a block diagram of a processing system.
Figure 4 is a schematic representation of a power grid.
Figure 5 is a schematic representation of a power grid.
Figure 6 is a schematic representation of a power grid.
Figure 7 is a graph showing changes in grid frequency.
Figure 8 is a flow chart of a method.
Figure 9 is a flow chart of a method.
Figure 10 is a flow chart of a method.
Figure 11 is a flow chart of a method.
Figure 12 is a flow chart of a method.
Figure 13 is a graph illustrating a process of deriving changes in load power from voltage measurements.
Figure 14 is a block diagram of a system comprising the processing system.
Figure 15 is a flow chart of a method.
Figure 16 is a block diagram of a system comprising the processing system.
Figure 17 is a flow chart of a method.
Figure 18 is a block diagram of a system comprising the processing system and a control system.
Figure 19 is a flow chart of a method.

## DETAILED DESCRIPTION OF EMBODIMENTS

Embodiments of the invention will be described with reference to the drawings. In the drawings, similar or identical reference signs designate elements with similar or identical configuration and/or function.

While embodiments will be described in association with processing systems and methods of determining an inertia of a generator equivalent model, the embodiments are not limited thereto. The techniques disclosed herein may be used to determine other response parameters that determine quantitatively by how much a grid frequency changes in response to disturbances. Examples of such response parameters comprise any one or any combination of: inertia, damping, governor time constant, governor gain, load sensitivity to voltage magnitude. The determined response parameter(s) may be a parameter of a power swing equation that establishes a relationship between the power grid frequency as a function of time and a change in power as a function of time, without being limited thereto.

While embodiments will be described in association with a power grid having power generating units comprising renewable energy resources, the embodiments are not limited thereto.

Processing methods and systems disclosed herein are operative to determine at least one response parameter. As used herein, the terms "determining" and "determine" encompass an approximate determination of the respective quantity, such as an estimation of the respective quantity.

As used herein the term "response parameter" refers to a quantity on which a change in grid frequency in at least part of a power grid in response to a disturbance is dependent. The response parameter may be dependent on a balance and/or imbalance of mechanical and electric energy in at least a part of the power grid. The response parameter may be related to a particular area of the power grid or the whole power grid. In the former case, separate response parameter(s) may be determined for several or all of the various areas of the power grid, allowing the inertia or other response parameter(s) to be determined in a spatially resolved manner.

As used herein, the term "response parameter" encompasses an inertia, without being limited thereto. The response parameter may comprise parameters of a power swing equation and/or governor equation or parameters derived therefrom (such as any parameter affecting a rate of change of frequency (RoCoF) or a frequency nadir).

As used herein, the term "at least one response parameter" may comprise or may be a parameter or combination of parameters that allows an effect of a further disturbance on grid frequency to be determined in a predictive manner, based on the at least one response parameter and a magnitude (e.g., a power), frequency information (e.g., a frequency or spectrum of the further disturbance), and location of the disturbance in the power grid is known. The "at least one response parameter" may comprise or may be a parameter or combination of parameters that allows an effect of a further disturbance on grid frequency to be determined in a predictive manner using linear response theory, wherein the linear response theory uses both the at least one response parameter and a magnitude (e.g., a power), frequency information (e.g., a frequency or spectrum of the further disturbance), and location of the disturbance in the power grid as input.

As used herein, the term "power grid" encompasses a power a transmission grid and/or a power distribution grid. The power grid may comprise both a power transmission grid and a power distribution grid.

As used herein the term "inertia" refers to inertia of a generator equivalent model (such as a single generator equivalent model) of at least part of a power grid.

As used herein, the term "power" refers to electric power.

In accordance with the invention, there are provided processing methods and systems for determining (and particularly for estimating) one or several response parameters of the grid response to a disturbance in the entire power grid or an area of the power grid using measurement data. Inertia is an example of such a response parameter. The systems and methods may be operative to determine one or other parameters of a single-generator equivalent of the power system. The systems and methods can perform reliable inertia estimation in grids that do not have full phasor measurement unit (PMU) observability.

Embodiments of the invention thereby address the need for more versatile and more accurate techniques of determining one or several response parameters that determine by which frequency shift a grid frequency is shifted by a further future disturbance. The one or several response parameters allow the change in grid frequency in response to a further disturbance to be predicted and/or allow suitable countermeasures (such as changing generator unit commitment) to be taken automatically or semiautomatically to keep the variation in grid frequency low (e.g., below a threshold and/or to minimum variation attainable).

The systems and methods may be operative to perform an inertia estimation for the power grid or an area within the power grid based on frequency measurements and knowledge about the disturbance occurring in the power grid.

The systems and methods may be operative such that effects of original disturbance are also considered in the estimation model. The effects of the original disturbance may comprise a change in load power and/or a change in loss power.

The systems and methods may be operative such that the knowledge about the disturbance comes exclusively from measurement data.

The systems and methods may be operative such that at least part of the knowledge about the disturbance comes from measured values that are used as bases for an approximation for unmeasured quantities in the power grid (e.g., voltage magnitude as measurement data that is used to derive a change in load power).

The systems and methods may be operative such that the disturbance is exogenous to the power grid.

The systems and methods may be operative such that the disturbance is controllable by controlling one or several devices capable of changing their power output.

The systems and methods may be operative such that one or several filtering techniques are applied to the received measurement data to improve the quality of the estimate. For example, narrow band-pass filtering can be used to extract the power grid response to the periodic controllable disturbance.

The systems and methods may be operative to set the frequency of the disturbance in a controlled way so as to not excite any undesirable dynamics in the power grid.

The systems and methods may be operative such that the at least one response parameter is determined through system identification techniques while taking into account the equations that govern the simplified equivalent of the power grid/area.

The systems and methods may be operative such that the at least one response parameter (such as estimated inertia of an equivalent generator) is dependent on an amount of kinetic energy in the power grid. Alternatively or additionally, the systems and methods may be operative such that the one or several response parameters (such as the inertia) may be used, optionally jointly with other parameters of the generator equivalent model, to simulate the grid frequency response to a further disturbance.

The systems and methods may be operative to allow a disturbance to be generated in a controlled manner such that the disturbance impact of the voltage magnitudes in the power grid is kept lower than a voltage change magnitude and/or is minimized.

The systems and methods may be operative to determine the at least one response parameter using an estimation based on a swing equation and/or an estimation based on an actively introduced probing signal. In the swing equation-based technique, the evaluation may be performed for a disturbance or several disturbances which is/are not specifically created for the purpose of inertia estimation but are introduced by, e.g., loads connected to the power grid that intermittently (e.g., regularly or non-regularly, but on an intermittent basis) draw increased power, thereby causing the grid frequency to shift. In the probing signal-based techniques, the systems and methods cause active injection of a probing signal into the power grid to cause excitation of the power grid frequency. The probing signal may be a sinusoidal or other periodically varying signal that is injected once or repeatedly, e.g., in an intermittent manner.

The systems and methods are operative to process power measurements and, where applicable, to approximate power values from, e.g., voltage measurements. In the latter case, the time-dependent variation of grid frequency in response to the disturbance may be combined with the measured time-dependent voltage to approximately determine the time-dependent change in power.

The systems and methods may be operative to determine the at least one grid response parameter (such as inertia) based on a total power deviation, which is composed of the power of the disturbance itself and the change of load and/or loss powers as a result of this disturbance. Thereby, the at least one grid response parameter is determined with enhanced accuracy as compared to techniques which rely on the power of the disturbance only, while neglecting the influence of the disturbance on loads and/or losses (and in particular while neglecting the influence of the disturbance on load and/or loss powers).

The systems and methods can estimate the at least one response parameter even when there is no full PMU observability in the sense that not all changes in load and/or loss and/or disturbance power can be obtained via respective PMUs. The systems and methods may be operative to replace the missing power data when determining the at least one response parameter. The systems and methods may be operative to approximately infer, from the measurements that are available such as changes in voltage magnitudes and/or individual changes in losses caused by the disturbance, the change of the load and/or loss power(s).

The systems and methods may be operative to use an identification technique which ensures convexity of an optimization problem solved to obtain the at least one response parameter. Thus, identification of a globally optimal solution for the at least one response parameter can be guaranteed, even when no PMU measurements are available for one or several of the summands summing up to the total power deviation in response to the disturbance.

The systems and methods may be operative to actively cause introduction of the disturbance, e.g., by means of one or several controllable apparatuses. The disturbance may be generated to have a periodic, in particular sinusoidal signal shape. The disturbance may be generated such that a power magnitude of the disturbance is less than a threshold. All measurement time series used as inputs for the estimation of the at least one response parameter may be filtered using a bandpass filter. A passband of the bandpass filter may be located, e.g. centered, at a frequency of the actively introduced disturbance (e.g., the frequency of a sinusoidal power variation introduced as disturbance). The bandpass filter may have a bandwidth less than (e.g., at most 0.1 times or at most 0.01 times) the frequency of the sinusoidal disturbance. The bandpass filtering allows the power grid's reaction to the disturbance to be distinguished from, e.g., background load variations.

The systems and methods may be operative such that, when the disturbance is generated under the control of a processing system using a controllable apparatus, the disturbance is generated and/or the measurements are processed in such a manner that an impact of the disturbance on voltage magnitude in the power grid is kept to below a voltage threshold, which helps reduce the load changes due to the disturbance and thus increases the estimation accuracy.

The systems and methods may be operative such that parameters of a single-generator equivalent of the power grid or an area in the power grid can be determined. This may be done in such a manner that at least an inertia that depends on (e.g., which reflects) a total kinetic energy stored in the power grid (such as in rotating parts of the power grid) is determined. Alternatively or additionally, the at least one response parameter may be determined which is not directly equivalent to the kinetic energy but can be used to predict the frequency evolution in the power grid following a further disturbance of a known size and location.

The systems and methods may be operative such that, when the disturbance is generated under the control of a processing system using a controllable apparatus, the frequency of the disturbance (e.g., the frequency of a disturbance that introduced a sinusoidal variation in power at a location in the power grid) is selected such as not to excite any resonance modes in the power grid. The disturbance is preferably generated to have a very narrow band to facilitate distinguishing the response to the disturbance from noise from background load variations. To this end, the time period over which the disturbance is applied may be much longer (e.g., at least 20, at least 30, at least 40, or at least 50 times) the duration of a period of the sinusoidal wave. The disturbance may be generated to have a smooth envelope, e.g., a Gaussian or Lorentz-curve-shaped envelope, to mitigate the introduction of unwanted frequencies into the power grid.

Various effects are attained by the systems and methods according to embodiments. The systems and methods according to embodiments allow at least one response parameter to be determined which is indicative of an amount of kinetic energy stored in in rotating masses of electric machines in the power grid. Inertia of a generator equivalent model is an example of such a parameter. The rotating masses may comprise rotating masses of synchronous generators and/or flywheel energy storage systems. The kinetic energy, as quantified by inertia, may represent an energy buffer against changes of frequency following a change in generation/demand.

The systems and methods according to embodiments provide enhanced techniques of determining response parameter(s) indicative of the kinetic energy of rotating components of the power grid. This facilitates planning (such as power generator unit commitment planning) and preventing low-inertia scenarios. Low inertia may lead to several problems. For illustration, the rate of change of frequency (RoCoF) and frequency nadir depend on the inertia. By implementing a power grid operation, based on the determined response parameter(s) such as inertia, a risk that frequency limits (e.g., $\pm 0.2$ Hz) are violated is reduced and may even be eliminated. Violating frequency limits is undesirable as it might lead to activation of load shedding, equipment disconnection, and potentially a cascading outage. A higher inertia level prevents such problems and gives a transmission system operator (TSO) higher security margin when operating the system. The present techniques, which allow inertia to be determined efficiently and accurately, thereby are useful to implement enhanced control and operation of a power transmission system.

The systems and methods disclosed herein provide techniques of estimating at least one response parameter that affects the change in grid frequency on a further disturbance, based on either a single disturbance or a series of disturbances. A disturbance may comprise a trip of a generator or a line interconnector. Other disturbances, whose size and onset time are known, e.g., through the SCADA system, can also be used. An example of such disturbance is the intermittent power consumption of an arc furnace.

The systems and methods disclosed herein may be applied to the entire power grid or any area of the power grid, provided that the flows through the tie lines connecting this area to the rest of the grid are monitored.

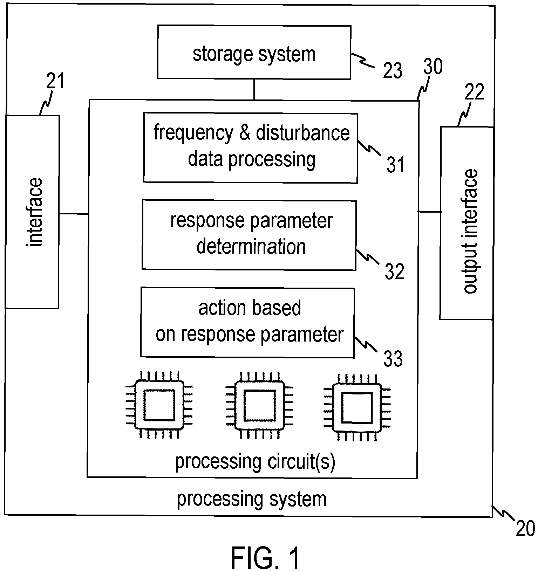

Figure 1 shows a processing system 20 operative to process data that includes measurements acquired or generated by one or several measurement instruments of a data acquisition system. The data comprises frequency measurements indicative of a change in grid frequency, as a function of time (e.g., in the form of time-series data), as caused by a disturbance. The data comprises PMU measurements and/or other measurements that allow changes in load and/or loss powers to be determined that occur in response to the disturbance. The processing system 20 may receive data indicative of the disturbance, such as one or more of: a disturbance power as a function of time (e.g., in the form of time-series data), a magnitude of the disturbance, frequency-resolved information on the disturbance (such as a center frequency of the disturbance power in Fourier space), a duration of the disturbance. The data indicative of the disturbance may come from measurement instrumentation (such as at least one PMU) or from a SCADA system or other control and/or monitoring system. When the processing system 20 determines parameters of a disturbance and controls at least one apparatus to introduce the disturbance into the power grid specifically for the purpose of determining the at least one response parameter, it is not required that the processing system 20 receives data indicative of the disturbance. In that case, the processing system 20 may store and use the determined parameters of the disturbance (such as a disturbance power as a function of time (e.g., in the form of time-series data), a magnitude of the disturbance, frequency-resolved information on the disturbance (such as a center frequency of the disturbance power in Fourier space), a duration of the disturbance) when determining the at least one response parameter.

The processing system 20 may be implemented as an apparatus comprising an apparatus housing in which the components illustrated in Figure 1 are accommodated. The processing system 20 may be implemented as a combination of several apparatuses that are communicatively coupled to each other. The processing system 20 may be operative to be used in combination with, and to co-operate with, a control system for at least part of the power grid, such as a transmission control system, a regional control center, or a national control center.

As explained in more herein, the processing system 20 is operative to process data comprising frequency measurements in response to the disturbance to determine at least one grid response parameter that influences the magnitude by which the grid frequency changes in at least part of the power grid in response to a further disturbance. The at least one response parameter determined by the processing system 20 may be one or several response parameters that, possibly in combination with other parameters, allow a future change in grid frequency to be predicted when a magnitude (e.g., power), frequency and/or time information (e.g., frequency spectrum), and location of the further disturbance are known. Inertia of a single generator equivalent is an example of such a response parameter.

The processing system 20 comprises at least one processing circuit 30. The at least one processing circuit 30 is operative to be coupled to at least one interface 21. The at least one processing circuit 30 is configured to receive data acquired or generated by measurement instrumentation, such as frequency measurements and/or time-dependent data indicating electric characteristics (such as PMU measurements or voltage measurements). The at least one processing circuit 30 is operative to perform a processing 31 of frequency measurements and data indicative of the disturbance. The at least one processing circuit 30 is operative to perform a determination 32 of at least one response parameter, based on the processing of the 31 of frequency measurements and data indicative of the disturbance. The at least one processing circuit 30 is operative to perform a determination 33 of at least one action that is based on the determined at least one response parameter.

The at least one processing circuit 30 may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

The processing system 20 may comprise an output interface 22. The processing system 20 may be operative to output a command that causes execution of the action determined by the action determination 33.

The processing system 20 may be operative to output a command that causes one or several of: provision of the at least one response parameter to a control and/or monitoring system (such as a SCADA system, a national control center, a regional control center) for ensuring grid stability; controlling a human machine interface (HMI) to output information on the determined at least one response parameter; controlling one or several controllable devices of the power grid to mitigate future changes in grid frequency and/or to ensure that the grid frequency stays within a predefined frequency range (which may have a width of, e.g., $\pm$ 0.2 Hz, or up to 0.2 Hz, or less).

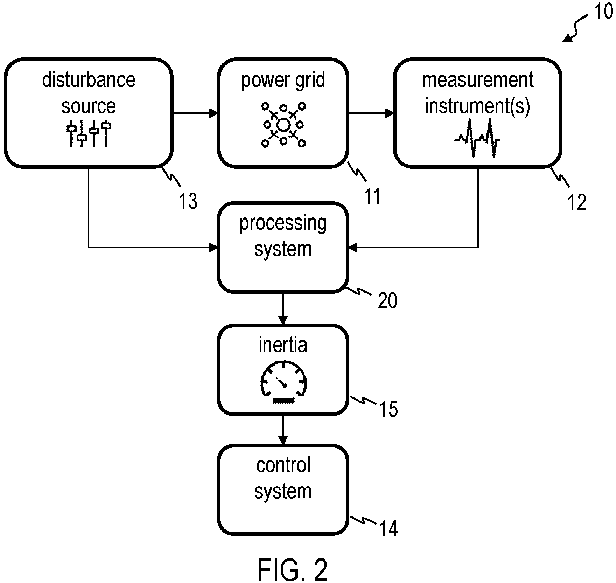

Figure 2 is a schematic representation of a system 10.

The system 10 comprises a power grid 11. The system 20 comprises the processing system 20 operative to determine the at least one response parameter (such as inertia) that affects or determines the change in grid frequency in response to a further disturbance.

A disturbance source 13 introduces the disturbance into the power grid. The processing system 20 may receive information on the disturbance (such a one or several of: a disturbance power as a function of time (e.g., in the form of time-series data), a magnitude of the disturbance, frequency-resolved information on the disturbance (such as a center frequency of the disturbance power in Fourier space), a duration of the disturbance) from the disturbance source 13 or from a system (e.g., a SCADA system) that controls and/or monitors the disturbance source. The disturbance source 13 may comprise a dedicated source provided for the specific purpose of introducing the disturbance for the purpose of determining the at least one response parameter. The disturbance source 13 may comprise loads connected to the power grid that intermittently draw increased amounts of power, such as an arc furnace.

The disturbance source 13 may comprise a controllable disturbance source. A frequency and/or magnitude of the disturbance introduced by the disturbance source 13 may be determined by the processing system 20, as explained in more detail elsewhere herein.

The system 10 comprises measurement instrumentation 12. The measurement instrumentation 12 may comprise PMUs and/or voltage measurement apparatuses, without being limited thereto. The measurement instrumentation 12 may be operative to acquire grid frequency measurements and provide the grid frequency measurements as well as power and/or voltage measurements to the processing system 20.

The processing system 20 may output at least one grid response parameter or a command that is dependent thereon. The processing system 20 may output an inertia 15 (e.g., an inertia of a single generator equivalent or an inertia of a power swing equation) for use by a control system 14.

The control system 14 may be operative to use the at least one response parameter (e.g., the inertia 15) to take mitigating actions that reduce a variation in grid frequency caused by a further disturbance before the further disturbance happens. The control system 14 may be operative such that the mitigating action(s) may comprise adjusting power generator unit commitment and/or increasing the kinetic energy of rotating components (such as rotating components of synchronous generators) so as to keep the grid frequency within a target frequency range even when the further disturbance is introduced.

The processing system 20 is operative to take not only into consideration the power of the disturbance but also the effects of the disturbance on load and/or loss power. The processing system 20 may be operative to determine a total power deviation as a sum of the disturbance power, change in loss power, and change in load power, respectively as a function of time. The total power deviation, as a function of time, may be processed in combination with the measured change in grid frequency, measured as a function of time, in a time interval after the disturbance has been introduced. Thereby, the at least one response parameter may be determined using, e.g., a power swing equation or other processing, as explained in more detail herein.

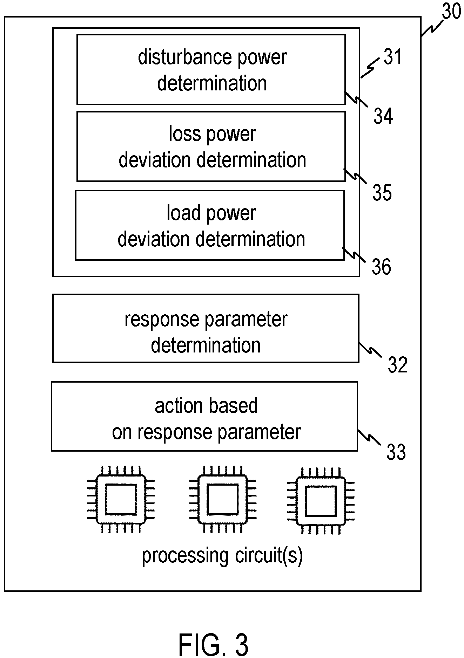

Figure 3 is a schematic block diagram of the at least one processing circuit 30 of the processing system 20. The at least one processing circuit 30 is operative to process measurements to perform a determination 35 of the change in loss power caused by the disturbance and a determination 3375 of the change in load power caused by the disturbance. Filtering or other pre-processing techniques may be applied to power and/or voltage measurements to distinguish contributions to the change in load and/or loss power caused by the disturbance from other root causes of variations in load and/or loss power. The determination of the change in load and loss power may determine the change in load and loss power as a function of time, e.g., in the form of time-series data.

The at least one processing circuit 30 is operative to perform a determination 34 of the disturbance power, to determine the disturbance power as a function of time. The determination 34 may but does not need to be based on measurements. For illustration, the determination 34 of the disturbance power may be based on data from a control system (such as a SCADA system) or from the disturbance source 13 or from disturbance parameter previously determined by the processing system 20 and stored in a storage system 23 of the processing system 20.

The at least one processing circuit 30 is operative to determine a total power deviation by summing the disturbance power and the changes in load and loss power. The total power deviation may be determined as a time-dependent function, e.g., in the form of time-series data.

The processing system 20 may be operative to process the time-dependent total power deviation with the time-dependent change in grid frequency to determine the response parameter(s), such as inertia.

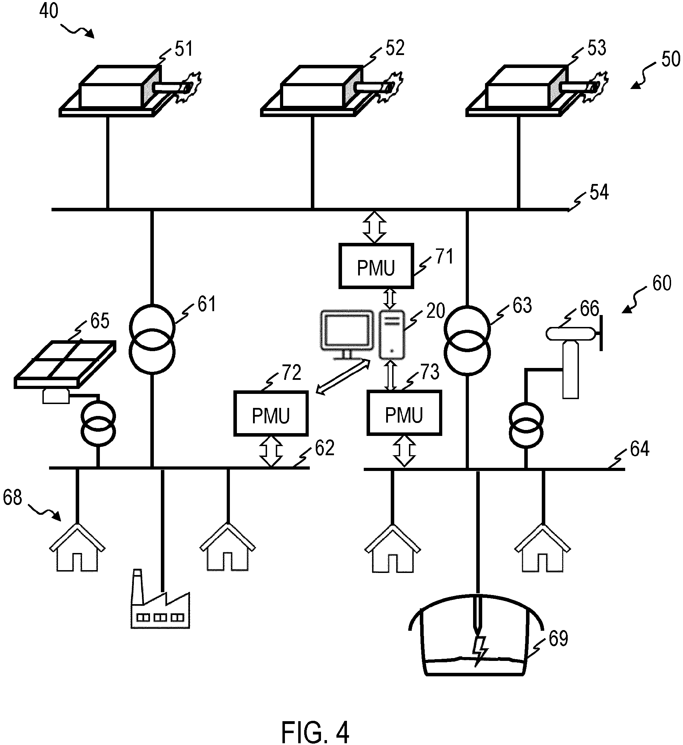

Figure 4 is a schematic view of a system 40, with power lines being shown as single line diagram. The system 40 comprises a power grid, comprising a transmission grid 50 and one or several distribution grids 60. One or several power generation units 51, 52, 53 may be configured to be coupled to a conductor 54 (e.g., a bus or power line) in the high voltage or extra-high voltage domain of the transmission grid 50. Rotating components of the power generation units 51, 52, 53 may store kinetic energy, contributing to frequency stability.

The distribution grid(s) 60 is connected to the conductor 54 of the transmission grid via power stations 61, 63 operative to step down the voltage to a low voltage (such as, e.g., 50 kV). Electric power is supplied to loads 68 via distribution buses 62, 64, for example. The loads 68 may comprise industrial loads, such as an arc furnace 69 that intermittently draws an increased amount of power, or another consumer of electric power that intermittently draws an increased amount of power.

The power grid may also comprise renewable energy sources 65, 66. The techniques disclosed herein provide a robust and reliable determination of at least one grid response parameter (such as inertia) even when there is renewables penetration of the power grid.

The system 40 comprises measurement instrumentation comprising at least one PMU 71, 72, 73. The measurement instrumentation may be operative to measure power flow and/or grid frequency at the voltage bus 54 and/or the distribution buses 62, 64.

The system 40 comprises the processing system 20. The processing system 20 is communicatively coupled to the measurement instrumentation. The processing system 20 and measurement instrumentation may be operative such that the processing system 20 receives the measurements in messages that are in conformity with IEC 61850, e.g., in conformity with IEC 61850-90, such as messages in conformity with IEC 61850-90-2:2016.

The processing system 20 is operative to determine the at least one response parameter, based on power measurements and taking into consideration the change in load and/or loss power caused by a disturbance. The disturbance may be introduced by a dedicated apparatus or by, e.g., a consumer 69 that intermittently draws an increased power level.

Results of the processing may then be provided to and used by a control system, e.g., to change power generator unit commitment and/or otherwise mitigate future grid frequency variations (e.g., by ensuring that the grid frequency remains within a target frequency range).

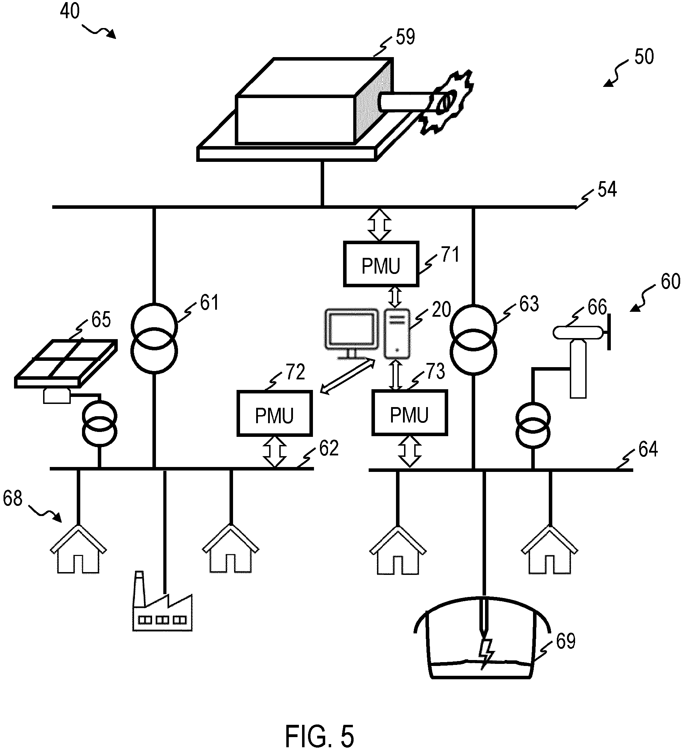

Figure 5 is a schematic representation of the system 40. The plurality of power generation units 51, 52, 53 is replaced by a single generator equivalent 59. The processing system 20 may be operative to determine one or several parameters of the single generator equivalent model (such as inertia) based on the measurements, taking into consideration the variation of grid frequency as a function of time and the total power deviation which includes both the disturbance power and changes in load and loss power.

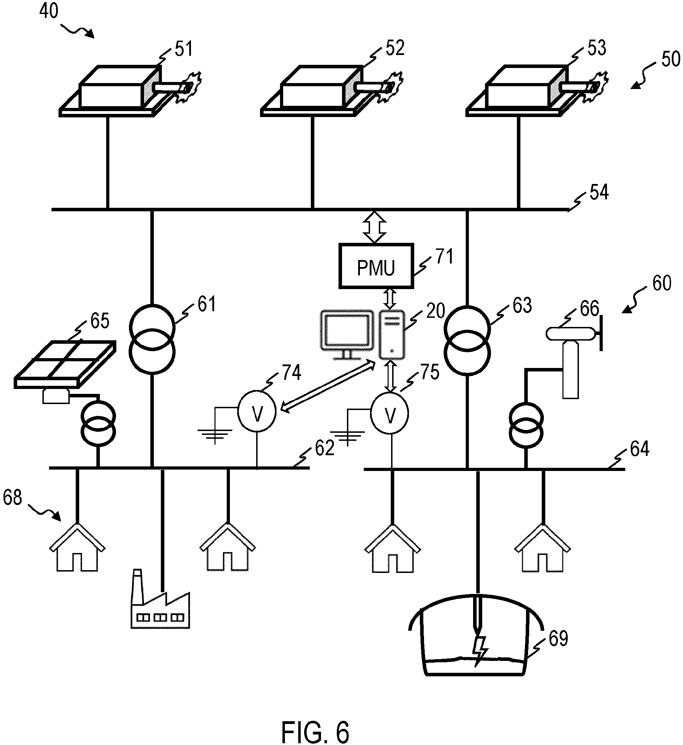

Figure 6 is a schematic representation of another embodiment of the system 40. The system 40 of Figure 6 does not have full PMU observability. The processing system 20 may be operative to determine the at least one response parameter based on the change in grid frequency, the disturbance power, changes in loss power, and changes in load power, respectively as a function of time and in response to a disturbance, even when there is no full PMU observability.

In this case, the processing system 20 may be operative to approximate the disturbance-induced change in load power as a function of time based on voltage measurements obtained using voltage measurement instrumentation 74, 75. This may be done using a processing technique which ensures convexity of an optimization problem solved to determine the at least one response parameter.

Alternatively or additionally, the processing system 20 may be operative to approximate the disturbance-induced change in loss power by performing a state estimate. The required state information may be retrieved by the processing system 20 from a control and/or monitoring system, such as a SCADA system.

Various processing techniques that allow the processing system 20 to determine the at least one response parameter will be described in detail below. For illustration, the processing system 20 may apply any one or any combination of processing techniques that solves an optimization problem with an objective of minimizing a metric that quantifies how strongly a measured grid frequency change in response to the disturbance is observed by measurements deviates from a grid frequency change theoretically expected for the disturbance when applying a candidate for the at least one response parameter. The candidate response parameter(s) that causes the metric, computed over a time interval after the disturbance, to have a minimum value is then the determined at least one response parameter. The determined at least one response parameter may subsequently be used tool automatically predict further excursions of the grid frequency in response to a further disturbance and/or take mitigating actions (such as adjusting generator unit commitment) that ensure that the grid frequency stays within a target frequency range.

Other metrics or other processing techniques may be used, potentially depending on which response parameter is to be determined.

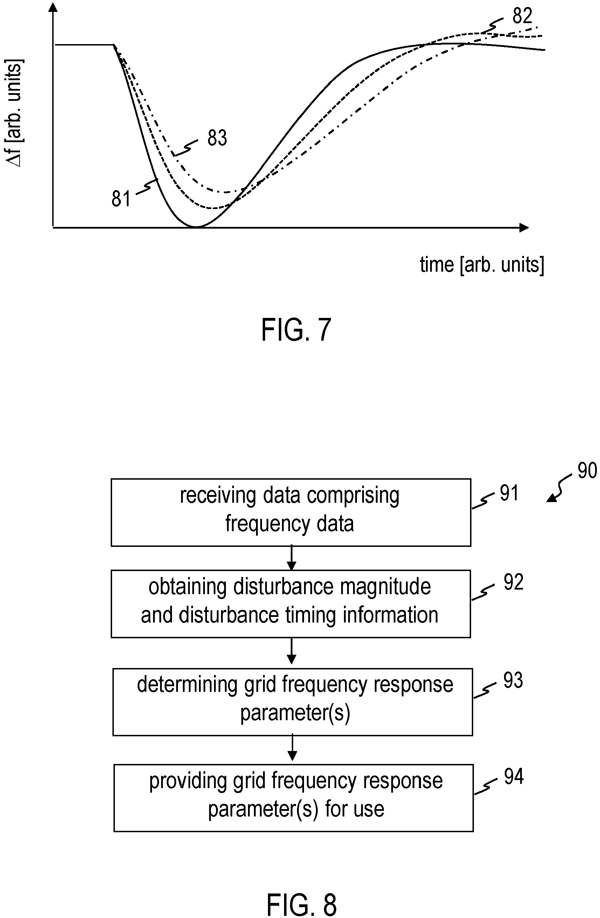

Figure 7 is a graph representing a measurement of a grid frequency 81 in response to a disturbance. Characteristics of the curve 81 that are widely used in the art at the rate of change of frequency (ROCOF) and/or the frequency nadir, represented by the lowest point of the curve 81.

Various computed frequency curves 82, 83 are illustrated for different candidate response parameter(s). The frequency curves 82, 83 are computed using information on the disturbance as well as one or several response parameters (such as inertia). The processing system 20 is operative to identify the at least one response parameter such that the frequency variation computed for this at least one response parameter is most similar, in accordance with a metric and evaluated over a time interval after the disturbance, with the measurement 81. The metric may be an L2-metric or another metric, also depending on the type of response parameter(s).

The processing system 20 may be operative to determine the inertia as a response parameter based on the ROCOF following the disturbance. When the power system is subjected to a large disturbance, the power imbalance in the inertial response stage is caused mainly by the electrical power deviation:

$$2H_{eq}\frac{d\Delta\omega_{eq}}{dt} = -\Delta P_e, \tag{1}$$

where $H_{eq}$ is the equivalent system inertia, $\Delta\omega_{eq}$ is the change in grid frequency with its derivative defined as ROCOF,

$$\Delta P_e = \Delta P_L + \Delta P_{dist}, \tag{2}$$

$\Delta P_L$ represents the power variations of frequency-dependent and voltage-dependent loads, and $\Delta P_{dist}$ is the size of the disturbance.

The processing system 20 may be operative to determine the ROCOF based on the frequency measurements taken at different times following the incipient time of the disturbance. To mitigate noise and sharp transient-type changes in frequency measurements, the processing system 20 may apply a processing that may comprise techniques such as filter and/or pre-processing of the frequency measurements, yielding a more accurate estimation of ROCOF. The accuracy in power imbalance estimation also has a significant impact on the inertia estimation. Thus, by taking into consideration the effect of the disturbance on loads and/or losses, a more accurate determination of the inertia is attained. Considering the impact of the disturbance on the loads and losses in the power grid mitigates drawbacks of conventional approaches, which conventional approaches (such as considering only the effect of the power of the disturbance) can lead to inaccurate results.

A determination of the inertia (which is exemplary for a response parameter that determines the change of grid frequency in response to a further disturbance) based on Equations (1) and (2) is possible even when the disturbance is a single event of a certain magnitude, such as a disconnection or circuit breaker (CB) trip.

The processing system 20 may be operative to additionally or alternatively process total power deviation, composed of disturbance power, change in loss power, and change in load power, when the disturbance is introduced in a controlled manner, using a controllable apparatus that purposively introduces the disturbance to change a balance between electrical and mechanical power, resulting in a change in grid frequency. The processing system 20 may be operative to cause a continual change in disturbance power, such as by controlling a controllable apparatus to generate a continuous, modulated disturbance of a given frequency or frequency band. Filtering may be applied to the measurements to distinguish the grid response to the disturbance from noise. Such techniques allow the at least one response parameter to be determined using a disturbance having a smaller magnitude than in the above-described approach that derives the at least one response parameter based on the response to a disconnection or CB trip. The at least one response parameter (such as inertia) can be determined with enhanced accuracy even when the disturbance that is introduced in a purposive manner for estimating the grid response parameter(s) has a small magnitude.

The processing system 20 may be operative to use a sinusoidal or multi-sine disturbance of a system state to identify the inertia or another grid response parameter, based on the total power deviation. The processing system 20 may perform a selection of the frequency or frequencies, taking into consideration a potential impact of the frequency or frequencies on the power grid's resonance modes. The processing system 20 may perform bandpass filtering for distinguishing the grid's response to the disturbance from noise.

The processing system 20 may be operative to determine the at least one response parameter for both sudden disturbances (representable as step changes) and intermittent (e.g., periodic) disturbances signals. Thus, the processing system 20 is suitable for performing the determination of the at least one response parameter from the total power deviation for any of various types of electrical disturbance. These include passive (uncontrollable) electrical disturbances - such as generator trips or disturbances caused by load step changes - or active (controlled, injected) disturbances that are created by the user using controllable devices, such as HVDC devices or batteries.

In the case of passive disturbances such as generator trips, the processing system 20 may be operative to perform a single estimation per disturbance, making the inertia estimate sporadic and infrequent. For intermittently recurring (e.g., regularly recurring) disturbance, recurring (e.g., regularly recurring) estimations can be performed by the processing system. The determination of the at least one response parameter can be performed on a recurring basis, e.g., with a repetition time which is on the order of hours or minutes. An example of a regular, non-controlled disturbance is the operation of an arc furnace. The disturbance size can be determined either based on an output of a measuring device at the disturbance source or through estimation techniques.

When the disturbance is actively introduced under the control of the processing system 20 for the purpose of determining the at least one response parameter, the rate at which the at least one response parameter is determined or updated may be set responsive to a user input received by the processing system 20. The active introduction of the disturbance will cause frequency deviation, and the changes in load and/or loss powers as well as the change in frequency may be used in combination with the known parameters of the disturbance to determine the at least one response parameter. The processing system 20 may be operative to select the magnitude and frequency (e.g., sine wave frequency of a sinusoidal disturbance power) of the disturbance based on characteristics of the power grid, in particular based on known electrical and/or mechanical resonances of the power grid.

Exemplary techniques of the processing that may be performed by the processing system 20 will be described in more detail next. While some of the techniques are described in association with a response parameter that comprises inertia, the embodiments are not limited thereto. Other response parameters may be determined instead of or in addition to inertia.

*Model*

The processing system 20 may use a model in which the power grid or an area of the power grid is modeled using a single equivalent generator (as schematically illustrated in Figure 5), having an inertia being equal to the inertia of the grid/area. This approach simplifies the problem to be solved, making it easier to process the measurements during field operation. It is not required that the at least one response parameter (such as inertia) be determined at every bus in the power grid/area. The aggregate value(s) such as inertia of a single generator equivalent provide the most relevant information for predicting grid frequency changes and represent a quantity that the TSO is ultimately interested in. Considering the typical timescale of frequency events, it is not adamant that fast-acting controls (such as automatic voltage regulation) in the equivalent generator be modeled.

The main equation used for the estimation is the so-called swing equation, which relates the generator inertia and damping with the imbalance between the electrical energy demand in the power grid and mechanical energy coming from the prime mover:

$$2H\Delta\dot{\omega} = \Delta P_m - \Delta P_e - D\Delta\omega - P_{dist} \qquad (3)$$

where $H$ is the inertia, $D$ is damping, $\Delta$ denotes the deviation of a quantity from the pre-disturbance value, $P_m$ is the

mechanical power applied to the rotating component (e.g., turbine), $P_e$ is the total electrical demand, $P_{dist}$ is the disturbance occurring in the power grid (such as a load step change, trip of a generator or an interconnector line), $\omega$ and $\dot{\omega}$ are the frequency and its derivative, respectively.

For periodic disturbances, the mechanical power deviation $\Delta P_m$ is assumed to be zero as the turbine governor will not react to them due to a high frequency of the disturbance, short measurement window, or governor dead bands. For large disturbances, $\Delta P_m$ can be estimated by posing a first-order governor equation:

$$T\Delta P_m = -\Delta \dot{P}_m - K\Delta\omega \qquad\qquad (4)$$

where $T$ and $K$ are the governor's time constant and gain, respectively.

The electrical power deviation $\Delta P_e$ consists of several additive terms

$$\Delta P_e = \Delta P_{load} + \Delta P_{losses} + \Delta P_{tie\ lines}, \qquad\qquad (5)$$

wherein:

- $\Delta P_{load}$ is a total change of the active power consumed by the load(s) as a result of the disturbance. The active power may depend on both the frequency and magnitude of the voltage at their bus, both of which can change as a result of the disturbance.
- $\Delta P_{losses}$ is the total change of the active power losses (e.g., in transmission lines and transformers) as a result of the disturbance. Large disturbances may cause the redistribution of the power flows due to the primary frequency control of generators, thus changing the losses.
- $\Delta P_{tie\ lines}$ is the total change of the active power flows in the tie lines as a result of the disturbance. This term may be omitted. In particular, this term may be taken into account selectively when determining a response parameter (such as inertia) for an area of the power grid and not entire grid. When determining the at least one response parameter (such as inertia) for an area, including this term helps isolate the area from the rest of the power grid and provides a more accurate estimate of the at least one response parameter for the respective area.

In equations (3), (4), and (5) above, quantities $H, D, K,$ and $T$ are scalars that represent the parameters of an equivalent generator, while all other quantities are time series. The processing system 20 may be operative to determine one, some, or all of the parameters $H, D, K,$ and $T,$ using measurements included in the data. The processing system 20 may be operative to determine at least the parameter $H,$ based on the measurements included in the data. The measurements included in the data may comprise measurements that define or allow the processing system 20 to at least approximately determine the time-dependent change in $\Delta P_{load}$ and $\Delta P_{losses}$ in response to the disturbance. The measurement data used by the processing system may comprise at least the time-dependent grid frequency (e.g., in the form of time-series data) in response to the disturbance.

The equations (3)-(5) above serve as an example and the invention is not limited to using these exact equations. Parameters of other parametric equations modeling the behavior of the grid frequency in response to the disturbance may be determined by the processing system, as an alternative or in addition to the parameter of the above-described model.

For illustration, the processing system 20 may be operative to determine one or several parameters of a higher-order governor equation. These parameter(s) may be used to predict the frequency change in response to a further disturbance, the parameters (such as magnitude, frequency, location) of which are known in advance.

For further illustration, the processing system 20 may be operative to determine one or several parameters of a higher-order swing equation. These parameter(s) may be used to predict the frequency change in response to a further disturbance, the parameters (such as magnitude, frequency, location) of which are known in advance.

For further illustration, the processing system 20 may be operative to determine one or several parameters of a higher-order swing equation or governor equation with additional terms, which may be nonlinear terms.

The reduction of the grid/area to a single equivalent generator has an underlying assumption that the parameters of this generator are constant. The processing system 20 may be operative to take into consideration that, at the onset of a disturbance, only the inertia in its immediate vicinity is available by the processing disclosed herein. In other words, when processing measurements, the processing system 20 may be operative to take into consideration that changes in grid frequency and in loss and/or load power are initially more pronounced in proximity to the disturbance and are noticeable at larger distances from the disturbance only with some delay. The processing system 20 may accommodate these effects using a spatially-dependent processing of measurements. For illustration, measurements may be weighted in a spatially-dependent manner depending on whether they are captured closer to or more remote from the location of the disturbance.

*Data used by the processing system and optional pre-processing*

The processing system 20 is operative to use the following data for determining the at least one response parameter:

- Data relating to the electrical disturbance $P_{dist}$.

    This data may but does not need to come from measurements. For illustration, when the processing system 20 determines the at least one response parameter using an active disturbance of the power grid that is introduced for the purpose of determining the at least one response parameter, the processing system 20 may use a priori knowledge of this disturbance (such as location, magnitude, frequency, duration). The processing system 20 may be operative to determine these characteristics of the disturbance, optionally using knowledge of electrical and/or mechanical resonances of the power grid and may cause the disturbance to be introduced. The determined characteristics may be stored by the processing system 20 in an internal storage 23 or externally for subsequent use in determining the at least one response parameter.
    The specific implementation of the disturbance-related data may vary, depending on the type of disturbance and its magnitude. For a disturbances such as load or generation step changes, the magnitude of the change and its inception moment or an approximation of the magnitude and inception moment are sufficient.
    For small, recurring disturbances, the time-series measurement data of the disturbance is used by the processing system 20. The frequency of controlled disturbances is preferably selected by the processing system 20 or a control system communicatively coupled with the processing system 20, such as not to excite any known grid resonances. The frequency ranges to be avoided may be known a-priori from system studies or obtained from a real-time oscillation monitoring system based on wide area monitoring system (WAMS). To reduce the impact of the controlled disturbance on voltage magnitudes in the power grid e.g., reactive power control may be used to mitigate the impact of the disturbance on loads and thus improve the estimation accuracy.

- Frequency measurement data $\omega$. The frequency measurements can be measurements acquired at a single measurement location or multiple locations. In the latter case, the processing system 20 may be operative to average measured frequencies to obtain the average grid frequency in the power grid or an area thereof. The processing system may take into account the distance of the measurement locations from the disturbance when determining the grid frequency that is then processed. Spatially-dependent weighting or averaging techniques may be used.

The processing system 20 may optionally be operative to use one or several of the following data for determining the at least one response parameter:

- Measurements/values of line flows and active power demand. These quantities can be directly measured, or the processing system 20 may be operative to estimate these quantities using state-estimation techniques.
- Voltage magnitude measurements at different buses in the power grid. The processing system 20 may be operative to estimate the load change as a result of the disturbance based on the voltage magnitude measurements, as described in more detail elsewhere herein.
- Snapshots (such as time-discrete, optionally sporadic values) of total losses. These could be either directly measured or estimated by the processing system using state-estimation techniques. The processing system 20 may be operative to use the snapshots (i.e., time-discrete loss values) to approximately determine a time series of the load change as a result of the disturbance.
- Measurements of tie line flows $P_{tie\ lines}$. These measurements are optional and are useful in case the at least one response parameter is determined for an area of the power grids. The processing system 20 may be operative to optionally take into consideration the tie line power flows for estimating inertia or other response parameter(s) in a given grid area. Accuracy can be further improved thereby.

Preferably, time-series measurement data used by the processing system are time-synchronized to facilitate the processing by the processing system. Time synchronization is achievable by using the corresponding measurement equipment such as PMUs or applying synchronization methods after collecting the data. If the incipient time of a disturbance is unknown, the processing system 20 may be operative to estimate the incipient time using signal processing or similar techniques.
Once the data for estimation is collected and synchronized, the processing system 20 may optionally perform a pre-processing. The pre-processing can be useful for both active and passive estimation (i.e., with or without use of a dedicated disturbance source that is controlled for the specific purpose of determining the at least one response parameter) to reduce the estimation error. The processing system 20 may be operative to apply filtering techniques to distinguish power flow(s) caused by the at least one disturbance from other background signals. However, the techniques disclosed herein can in principle also work without such pre-processing. Filtering can be omitted if the measurement noise is low, the grid is small, or larger estimation errors are acceptable.

The processing system 20 may be operative such that the type of pre-processing (such as normalizing data, filtering, and other conditioning or pre-processing steps) can be dependent on the specific type of power grid and measurement equipment.

The processing system 20 may be operative to perform low-pass filtering for passive estimation (i.e., when the disturbance is caused by an apparatus that is not controlled in a dedicated manner for introducing the disturbance for the specific purpose of determining the at least one response parameter). This allows the system identification technique to retain a slow time constant shape of the frequency response.

Alternatively or additionally, the processing system 20 may be operative to perform narrow bandpass filtering for active disturbance (i.e., when the disturbance is introduced by a controllable apparatus that is controlled in a dedicated manner for introducing the disturbance for the specific purpose of determining the at least one response parameter). This allows the processing system 20 to distinguish information (such as power flows and/or grid frequency variations) at the frequency at which the grid was excited by the disturbance from noise and other phenomena in the power grid that are not related to the disturbance.

The processing system 20 may be operative to perform grid-specific pre-processing techniques. Such grid-specific pre-processing techniques may include using the weighted average for frequency and voltage measurements based on the knowledge of grid topology and operating conditions, delaying the active estimation procedure for a certain time until the transient response of the grid to the disturbance dies down, without being limited thereto.

*Metric used by the processing system*

The processing system 20 may be operative to use a metric that is maximized or minimized to obtain the best value(s) for the at least one response parameters. Inertia or other parameters of an equivalent generator model are examples for such response parameter(s).

For inertia estimation, it is particularly relevant to predict how the power grid will react to a given further disturbance. To this end, any one or any combination of two types of inertia estimate can be determined:

- The value that reflects the total kinetic energy of rotating components (e.g., of synchronous generators and, optionally, of rotating energy storage systems if present) in the power grid or area of the power grid.
- The value that does not have physical meaning but, taken in combination with other parameters of an equivalent generator, allows the frequency evolution to be predicted that is expected in response to the further disturbance, given that the magnitude and location of the further disturbance are known.

To evaluate the quality of the two types of inertia estimate, the processing system can use a Mean Absolute Error (MAE) between ground truth and estimated inertia. The true value of inertia can be approximated by the processing system 20 using, e.g., by summing up the generator inertia and making assumptions on the percentage of load inertia.

The processing system 20 may be operative to determine the inertia as a response parameter even in the absence of information on the true value of the inertia. Various types of metrics can be used to that effect.

The processing system 20 may be operative such that a metric based on a one-step-ahead prediction error is optimized (e.g., the response parameter(s) are determined to have those value(s) for which a prediction error becomes minimum). Thus, the processing system 20 may be operative to use a difference between the actual frequency measurement and the predicted frequency of an equivalent generator for the next time step given its frequency at the previous time steps. Implementations of this type of metric and the determination of the values which cause the metric to be optimum (i.e., the prediction error to be minimum) are available to the skilled person.

The processing system 20 may be operative to use a metric which relates to the overall frequency response prediction. Instead of focusing only on one-step-ahead prediction, the processing system 20 may determine the value(s) for the at least one response parameter(s) such that a window of frequency measurements is used for determining the at least one response parameter.

An example of such metric for a large disturbance can be a weighted sum of the RoCoF error, error of the time of nadir, error in the nadir value, and the steady state value of the frequency:

$$pp = w_1 e_{rocof} + w_2 |t_{nadir} - \tilde{t}_{nadir}| + w_3 |y_{nadir} + \tilde{y}_{nadir}| + w_4 |y_{ss} - \tilde{y}_{ss}|, \qquad (6)$$

where a tilde over the variable $\tilde{x}$ denotes the estimated value and the value without tilde being the ground truth. The weights are tuning parameters that can be adjustable. At least some of the weights may be zero.

Thus, the processing system 20 may be operative such that it identifies the value(s) for one or several response parameter(s) (such as inertia and/or other parameters of a generator equivalent) such that a weighted average of at least two of RoCoF error, error of the time of nadir, error in the nadir value, and the steady state value of the frequency is optimized (typically minimized).

Using the metric of Equation (6), the processing system 20 can generally determine the values of the at least one response parameter(s) that provide the minimum value for Equation (6). For a multidimensional parameter space, optimization techniques such as gradient descent may be used. The processing system 20 may perform a perform parameter sweep to determine the value(s) for the at least one response parameter(s) that maximize the overall frequency fit of the identified system. I.e., the identified response parameter(s) are such that the change in grid frequency observed for the disturbance is best reproduced by these values of the identified response parameter(s), causing the metric of Equation (6) to have an absolute minimum.

The processing system 20 may employ techniques of model reduction. The determination of the response parameter(s) can be performed on different orders (including at least the third order) and then reduced to first or second order models. Thereby, the required response parameter(s) can be determined using conventional approximation techniques and then mapped onto the model of the power grid generator(s) that is used. During this process, there are multiple parameters, and the best parameter combination is the one that maximizes the overall frequency response prediction. While none of the parameters of the reduced system may necessarily directly correspond to a physical quantity, they serve as a good predictor of the frequency evolution in the power grid following a further disturbance.

*Response parameter determination*

For the equivalent generator model (either just the swing equation, or with the governor equation), the processing system 20 may be operative to determine the response parameter(s) that determine the evolution of the grid frequency in response to disturbances. Various implementations are available to the skilled person, such as grey box identification, Kalman filtering (unscented or extended), autoregressive exogenous (ARX) model, or others.

A further improvement is attained by a processing system 20 operative to ensure robustness of the solution. Thereby, the risk of non-convexity giving rise to physically meaningless solutions when using conventional processing techniques is mitigated.

Equations (3)-(5), which relate to the generator equivalent, may be formulated as follows

$$2H\Delta\dot{\omega} = \Delta P_m - \Delta P_{load} - \Delta P_{losses} - \Delta P_{tie\ lines} - D\Delta\omega - P_{dist} \tag{7}$$

$$T\Delta P_m = -\Delta\dot{P}_m - K\Delta\omega \tag{8}$$

When all power time series in these equations are known based on measurements or derived based thereon, techniques such as an ARX model technique may be used with the second-order model to find the transfer function coefficients of the corresponding discrete dynamical system:

$$\Delta\omega(t) + a_1\Delta\omega(t-1) + a_2\Delta\omega(t-2) = b_1\Delta P(t-1) + b_2\Delta P(t-2) + e(t) \tag{9}$$

where $t$ is the time step, e is the noise term, $\Delta P = P_{dist} + \Delta P_{load} + \Delta P_{losses} + \Delta P_{tie\ lines}$ is the total power of the disturbance, and $a_1, a_2, b_1, b_2$ are coefficients to be identified. These coefficients can be found using e.g., the OR decomposition method. The parameters of the equivalent generator can be determined through this unique mapping:

$$H = -\frac{t_s}{2b_1} \tag{10}$$

$$D = -\frac{b_1 - b_2 + a_1 b_1}{b_1^2} \tag{11}$$

$$K = -\frac{a_2 b_1^2 + b_2^2 - a_1 b_1 b_2}{b_1^2 b_2 + b_1^3} \qquad (12)$$

$$T = \frac{b_1 t_s}{b_1 + b_2} \qquad (13)$$

where $t_s$ is the data sampling time. Hence, in such a setup of full observability the parameters of the equivalent generator can be found using the above-described or similar techniques, executed automatically by the processing system 20.

While four parameters are determined in the above technique, for small disturbances a first-order model is sufficient, which is characterized only by *H and D.* Thus, the processing system 20 may be operative to determine at least the parameters *H and D* as response parameters. These parameters can be used to adequately predict the frequency evolution in response to a further disturbance, provided that the magnitude of the further disturbance is less than a magnitude threshold.

Timeseries data for $\Delta P_{load}$ and $\Delta P_{losses}$ are available when the power grid has full PMU observability.

When the power grid does not have full PMU observability, the processing system 20 may be operative to approximately determine $\Delta P_{load}$ and $\Delta P_{losses}$ and use the determined values to compensate, at least in part, for the lack of full measurements observability of $\Delta P_{load}$ and $\Delta P_{losses}$,

The processing system 20 may be operative to approximately determine the time series of $\Delta P_{losses}$ as a step response-like time series, which is built using two snapshot values of the total losses: one shortly before the disturbance and one shortly after it. The processing system 20 may be operative to obtain these two snapshot values from a steady state estimator. Such a steady state estimator is typically run in the control center of any TSO. Alternatively or additionally, the processing system 20 may be operative to sum up time series of losses on PMU-monitored lines and then scale the sum accordingly based on the snapshots of the total losses coming from the steady state estimator.

The processing system 20 may be operative to approximately determine the deviation of the load power to the disturbance using time series measurements of voltage magnitudes. In case of multiple measurement locations, the processing system 20 may be operative to use an average or weighted average to determine a single voltage time series.

In the latter case, the processing system 20 may use a multiple input single output (MISO) ARX formulation, with one input being the load power deviation, and the other input being the voltage deviation. Alternatively, the processing system may be operative to perform a grey box identification based on physical equations.

Preferably, and as will be explained in more detail elsewhere herein, the processing system is operative to represent the load change as a result of a disturbance as a linear function of the voltage change:

$$\Delta P_{load} = \alpha \Delta V, \qquad (14)$$

where $\Delta V$ is the voltage time series and $\alpha$ is an unknown proportionality coefficient. To maintain convexity of the optimization problem, the processing system may be operative to perform a parameter sweep over different values of the proportionality factor $\alpha$. The solution of, e.g., the ARX formulation may then be performed, approximating the change in load power caused by the deviation by Equation (14) and implicitly also identifying the proportionality factor $\alpha$ which causes the metric to have an absolute maximum or minimum value, as considered as a function of not only the generator equivalent parameters but also of $\alpha$. This way, convexity of the optimization problem is retained, thus guaranteeing a reliable solution. The sweep range for $\alpha$ used for the parameter sweep can be set by the processing system 20 based on, e.g., a total load in the system.

The processing system 20 may be operative such that the optimization problem which minimizes or maximizes the metric is a constrained optimization problem. One or several constraint terms may be added to, e.g., enforce the stability, etc. Alternatively or additionally, the processing system need not identify parameters of a generator equivalent and/or power swing equation but can determine other response parameter. Alternatively or additionally, it is not required that voltage magnitude measurements be used in Equation (14). The techniques will remain operative for other measured quantities.

Figure 8 is a flow chart of a method 90. The method 90 may be performed automatically by the processing system 20.

At process block 91, the processing system 20 receives the data. The data comprise measurements. The measurements comprise at least frequency measurements indicating an evolution of a grid frequency in response to a disturbance. The measurements may comprise power measurements or measurements of other electric characteristics that allow a time-dependent evolution of a change in load power in response to the disturbance to be ascertained. That measurements may comprise power measurements and/or data from a steady state estimator that allow a time-dependent evolution of a change in loss power in response to the disturbance to be ascertained.

At process block 92, the processing system 20 may obtain information relating to the disturbance. The information relating to the disturbance may be retrieved from a storage 23 internal to the processing system 20 or a data repository external to the processing system 20. The supplies in particular when the disturbance is deliberately introduced for the purpose of estimating the at least one response parameter. Alternatively or additionally, the processing system 20 may be operative to derive the information relating to the disturbance from measurements received at process block 91. Information related to the disturbance may comprise at least a magnitude of the disturbance and timing information, such as an incipient time or an estimate of the incipient time.

At process block 93, the processing system 20 determines one or several response parameters. The one or several response parameters may comprise parameters of a generator equivalent model, parameters of a power swing equation, or other parameters of the near or non-linear response theory that allow the evolution of grid frequency in response to a further disturbance to be predicted, provided that the magnitude, location and, optionally, frequency of the further disturbance are known.

At process block 94, the processing system 20 may perform an action based on the at least one response parameter. Alternatively or additionally, the processing system 20 may provide the at least one response parameter to another system, such as a control center of ay TSO. The at least one response parameter may be used by the processing system 20 or a control system communicatively coupled to the processing system 20 to perform any one or any combination of: causing outputting of an alert of warning if an evolution of grid frequency predicted based on the at least one response parameter indicates that the grid frequency is expected to leave an acceptable frequency range; automatically changing generator unit commitment; automatically triggering a mitigating action which ensures that the grid frequency remains in the acceptable frequency range; using the at least one response parameter for a decision logic which determines whether a mitigating action is warranted to ensure that the grid frequency remains in the acceptable frequency range.

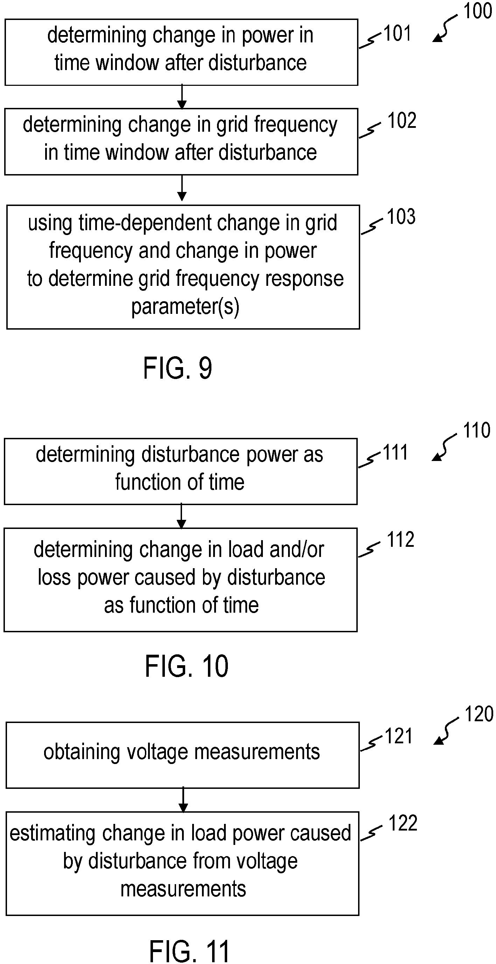

Figure 9 is a flow chart of a method 100. The method 100 may be performed automatically by the processing system 20.

At process block 101, the processing system 20 determines a time-dependent evolution of a power in response to a disturbance introduced into the power grid. The time-dependent evolution of the power may be a time-dependent evolution of a total power deviation which is composed of disturbance power, change in load power, and change in loss power. The time-dependent evolution of the power may be a time-dependent evolution of a total power deviation which is composed of disturbance power, change in load power, change in loss power, and change in tie-bar power.

At process block 102, the processing system 20 determines a time dependent evolution of grid frequency in at least a portion of the power grid. The processing system 20 may determine the time-dependent evolution of grid frequency based on measurements. Processing such as averaging or weighted averaging based on measurement location relative to the disturbance location may be performed for determining the evolution of grid frequency in response to the disturbance.

At process block 103, the processing system 20 determines at least one response parameter based on the time-dependent evolution of the total power determined at process block 101 and the time-dependent evolution of grid frequency determined at process block 102.

Figure 10 is a flow chart of a method 110. The method 110 may be performed automatically by the processing system 20. The method 110 may be performed by the processing system 20 to implement process block 101 in the method 100 of Figure 9.

At process block 111, the processing system 20 may determine a time-dependent evolution of the disturbance power as a function of time. The time-dependent evolution of the disturbance power may be determined based on, e.g., parameters used to actively control an apparatus that introduces a time-varying (e.g., sinusoidal or multi-sine) disturbance into the power grid.

At process block 112, the processing system 20 may determine the time-dependent evolution of loss power in response to the disturbance. The processing system 20 may determine the time-dependent evolution of loss power based on a steady state estimator output and/or PMU measurements and/or other electrical measurements. The processing system 20 may also determine the time-dependent evolution of load power in response to the disturbance. The processing system 20 may determine the time-dependent evolution of load power based on the individual measurements and/or other electric characteristics, assuming a linear relationship between the change in load power in the change in the voltage magnitude or other electric characteristic (such as, e.g., in Equation (14)), with a proportionality constant being determined by the processing system 20.

Figure 11 is a flow chart of a method 120. The method 120 may be performed automatically by the processing system 20. The method 120 may be performed by the processing system 20 to implement the determination of the change in load power at process block 111 in the method 110 of Figure 10.

At process block 121, the processing system 20 obtains voltage measurements. The voltage measurements may be or may comprise voltage magnitudes for at least one bus to which load(s) are connected.

At process block 122, the processing system 20 estimates the change in load power caused by the disturbance from the change in voltage magnitude caused by the disturbance. A proportionality constant that links the change in load power to the change in voltage magnitude may be determined by the processing system 20 in such a manner that the metric is optimized not only over the at least one response parameter to be determined, but also over the proportionality constant.

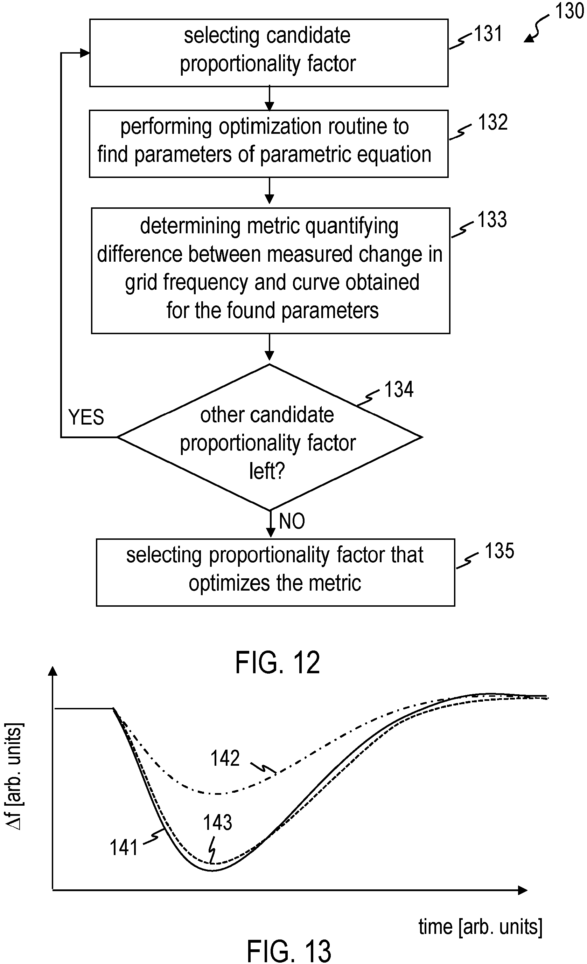

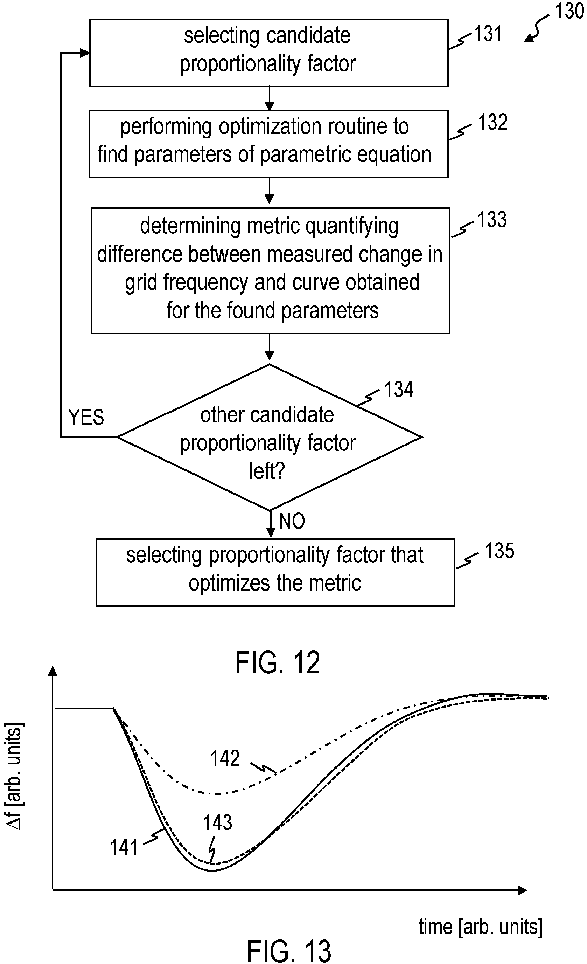

Figure 12 is a flow chart of a method 130. The method 130 may be performed automatically by the processing system 20. The method 130 may be performed by the processing system 20 to implement the determination of the change in load power based on a voltage magnitude at process block 122 in the method 120 of Figure 11. The method is an optimization routine that determines a proportionality factor between the change in load power caused by the disturbance and the measured change in voltage magnitude caused by the disturbance.

At process block 131, the processing system 20 selects a candidate proportionality factor. The candidate proportionality factor may be chosen from a proportionality factor range. The proportionality factor range may be set in dependence on a total load.

At process block 132, the processing system 20 performs an optimization routine to find at least one parameter of a parametric equation (such as a generator model and/or power swing equation) that links the time-dependent evolution of the grid frequency in response to a time-dependent evolution of the total power deviation caused by the disturbance.

At process block 133, the processing system 20 determines a value of a metric that quantifies a difference between the measured evolution of the grid frequency and the evolution calculated for the identified optimal parameters. This value depends on the candidate proportionality factor.

At process block 134, it is determined whether any other candidate proportionality factor its left. For illustration, the processing system 20 may determine whether a sweep has been performed over the full sweep range. If any other candidate proportionality factor is left, the method returns to process block 131.

At process block 135, the proportionality factor for which the value of the metric 133 is at a global optimum (which may be a minimum or a maximum, depending on the metric considered) is chosen. The at least one response parameter that defines the global optimum for the metric is defined by the parameter value(s) determined at process block 132 for the respective proportionality factor.

Figure 13 illustrates operation of the methods of any of Figures 8-12.

Figure 13 shows a time-dependent evolution of a measurement 141 of grid frequency in response to a disturbance. Figure 13 also shows time-dependent evolutions of grid frequency 142, 143 determined for different values of the at least one response parameter in, where applicable, of the proportionality constant that links the change in load power to a measured change in an electric characteristic (such as in Equation (14)). The methods disclosed herein provide at least one response parameter which is useful to computationally determine, if required in a predictive manner, a time-dependent evolution 143 of the grid frequency which mimics the actual measured evolution 141.

In any one of the processing systems, methods, and systems disclosed herein, the processing system 20 may be operative to interact with a disturbance source 13 that is controllable. The processing system 20 may be operative to determine parameters of the disturbance as generated by the disturbance source 13.

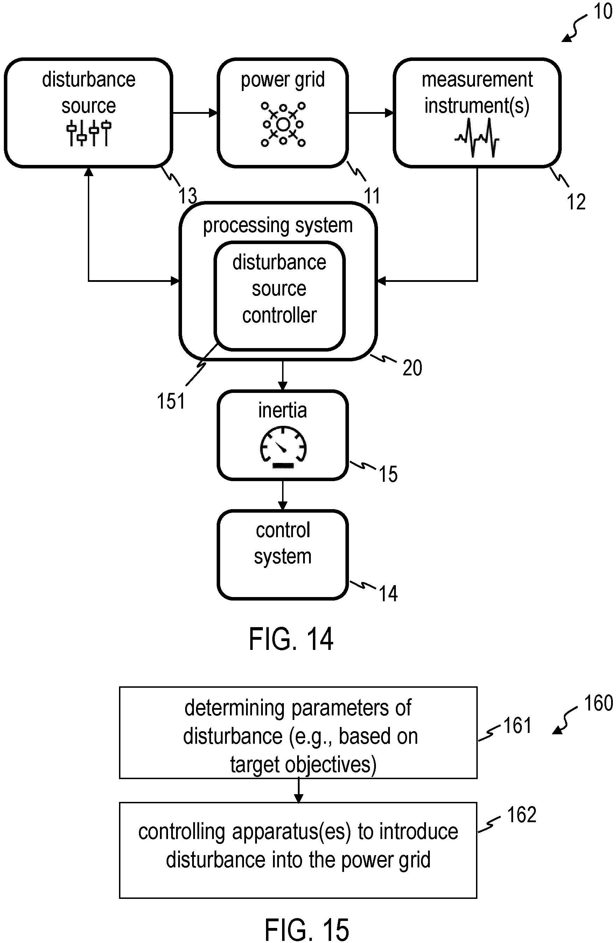

Figure 14 shows a block diagram of the system 10. The disturbance source 13 is controllable by a disturbance source controller 151 of the processing system 20. The disturbance source 13 may also feed the data or measurements to the processing system 20. The processing system 20 may be operative to receive the data or measurements from the disturbance source 13 and may use this information for determining the at least one response parameter.

While a single disturbance source 13 is schematically shown in Figure 14, the processing system 20 may be operative to control several disturbance sources that may be arranged at various locations of the power grid 11.

Figure 15 is a flow chart of a method 160. The method 160 may be performed automatically by the processing system 20. The method 160 may be performed automatically by the processing system 20 for determine parameters for controlling the disturbance source 13, such as a magnitude, time dependence, and/or a location of the disturbance that is being introduced into the power grid under the control of the processing system 20.

At process block 161, the processing system 20 determines one or several disturbance parameters of the disturbance. The one or several disturbance parameters may be determined based on one or several target objectives, such as avoiding the excitation of any known electrical and/or mechanical resonances in the power grid. The processing system 20 may determine a frequency of a sinusoidal disturbance or oil or frequencies of a multi-sine disturbance and/or an envelope of the disturbance such that all spectral components of the disturbance is spaced from known electrical and/or mechanical resonances in the power grid by at least a given minimum spacing. The given minimum spacing may be fixed or may be configurable.

At process block 162, the processing system 20 may control one or several apparatuses to introduce the disturbance into the power grid, in accordance with the disturbance parameters determined at process block 161.

In any one of the processing systems, methods, and systems disclosed herein, the processing system 20 may be operative to effect a mitigating action which reduces or possibly even eliminates a change in voltage magnitude at the load(s) that is caused by the at least one disturbance. In other words, the processing system 20 may be operative to take a counteraction to reduce changes in voltage magnitudes for the loads (with the reduction being attained as compared to the case when no counteraction is taken) that would otherwise be caused by the disturbance. This applies in particular when the disturbance is actively introduced into the power grid for the specific purpose of determining the at least one response parameter.

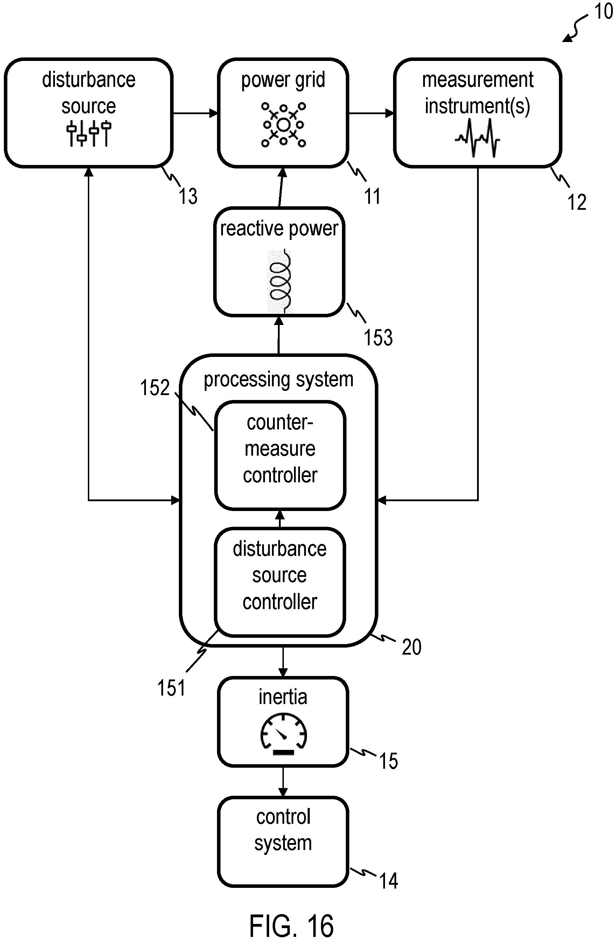

Figure 16 shows a block diagram of the system 10. The disturbance source 13 is controllable by a disturbance source controller 151 of the processing system 20.

The system 10 comprises at least one apparatus 153 that the selectively controllable by, e.g., the processing system 20 or a control system communicatively coupled to the processing system 20. The at least one apparatus 153 is operative such that, upon activation, it reduces a change in voltage magnitude of a load of voltage that would otherwise be caused by the disturbance introduced by the disturbance source 13. The at least one apparatus 153 may comprise an apparatus operative to a trust a reactive power. The at least one apparatus 153 may comprise a controllable reactive component, such as a controllable reactance.

The processing system 20 may comprise a countermeasure controller 152. The countermeasure controller 152 may be operative to determine whether the at least one apparatus 153 is to be controlled to reduce changes in voltage magnitude. The countermeasure controller 152 may be operative to determine a timing and/or other operating parameters of the at least one apparatus 153. While only one apparatus 153 is schematically shown in Figure 16, the system 10 may comprise a plurality of reactive apparatuses 153 operable under the control of the processing system 20 and deployed at various locations of the power grid 11.

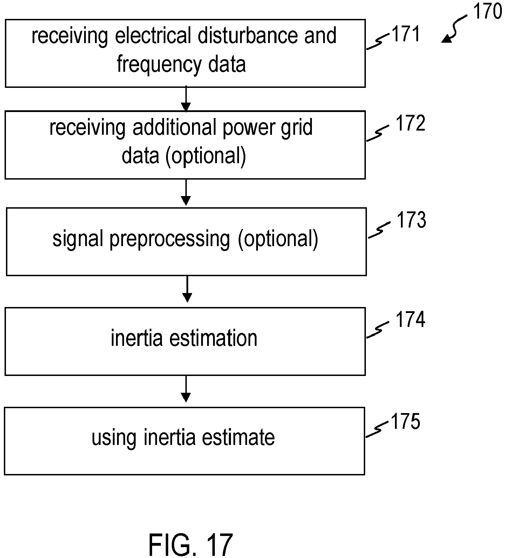

Figure 17 is a flow chart of a method 170. The method 170 may be performed automatically by the processing system 20 alone or in combination with a control system (such as a TSO control center) communicatively coupled to the processing system 20.

At process block 171, the processing system 20 receives data specifying the disturbance and the frequency data as response of the power grid to the disturbance. The processing system 20 may use the data specifying the disturbance to generate a time series of disturbance power values. The processing system 20 may use the data specifying the grid response for determining a time series of the total power deviation and a time series of grid frequency values in response to the disturbance. The processing system 20 may determine the at least one grid response parameter based on these time series.

At process bock 172, which is optional, the processing system 20 may collect additional data, such as tie line power flow, bus voltages, and loss snapshots. The collection of bus voltage magnitudes is of practical nature: the processing system may use the bus voltage magnitudes for approximately determining load power changes in response to the disturbance, when there is no appropriate measurement instrumentation for directly measuring the load power. If, however, the grid is fully observable, then load changes can be measured or calculated directly instead of using an approximate determination based on bus voltages. Additionally or alternatively, loss snapshots that are determined based on, e.g., a state estimation in a TSO control center, can be used by the processing system 20 for approximately determining the changes in loss power in response to the disturbance. If it is possible to directly measure the loss changes, the processing system 20 may use the measurements of the loss changes for even better accuracy.

At process bock 173, which is optional, the processing system 20 performs signal pre-processing. Depending on the type of disturbance (active disturbance or passive, large disturbance), the pre-processing may include low-pass filtering, bandpass filtering, and/or other processes, such as normalization, and removal of outliers.

At process block 174, the processing system 20 performs inertia determination through system identification. Any one of the techniques described in detail herein may be used for determining the inertia and/or other grid response parameters based on the time series obtained at process blocks 171 and 172.

The processing system 20 may be operative to extract the parameters from the identified system and map them to the parameters of an equivalent generator.

At process block 175, the determined at least one response parameter may be used to take an action. The action may comprise comparing the estimated inertia with the pre-determined threshold value, simulating the grid response to various disturbances, changing the balance of kinetic and electric energy to improve grid frequency stability and/or ensure that the grid frequency stays within a target frequency range even when any of a set of further disturbances is introduced, changing generator unit commitment to ensure that the grid frequency stays within a target frequency range even when a further disturbance is introduced, without being limited thereto.

If tie line power flows are available, the processing system 20 may separate the power grid into various distinct areas (separated from each other by tie lines) and may perform the determination of the at least one grid response parameter in an area-specific manner. The processing may be based on any of the techniques disclosed herein, with the tie line power flow being preferably taken into account when determining the at least one response parameter. Separation into multiple areas further increases estimation accuracy.

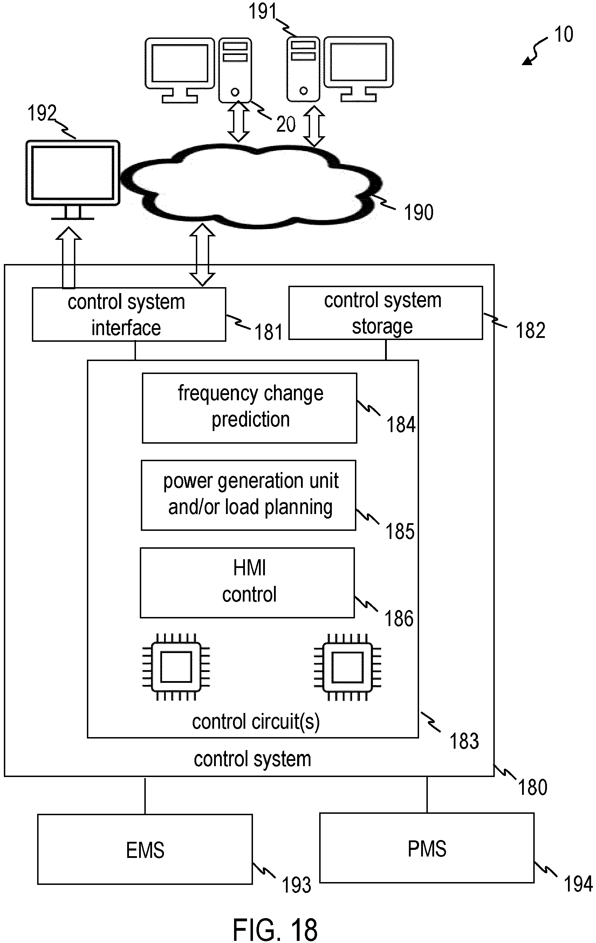

Figure 18 is a block diagram of a system 10 according to an embodiment. The system 10 comprises the processing system 20 which may be operative according to any one of the embodiments disclosed herein.

The system 10 comprises at least one server 191 operative to provide forecast information which has the potential of affecting grid frequency. The forecast information may comprise whether forecast information, in particular if the power grid has a renewables penetration. The forecast information may comprise load forecast information which may be based on historical data.

The processing system 20 and/or a control system 180 of the system 10 may be communicatively coupled with the at least one server 191 over a dedicated network or a wide area network 180 or the internet. The processing system 20 and/or the control system 180 may be operative to retrieve the forecast information from the at least one server 191 and to use the forecast information in combination with the at least one response parameter determined by the processing system 20 for predicting an expected future evolution of the grid frequency in response to a further disturbance, respectively assuming that the operating conditions of the power grid will be in accordance with forecast information.

The system 10 may comprise a human machine interface (HMI) 192 which may be communicatively coupled with the processing system 20 and/or the control system 180. The processing system 20 and/or the control system 180 may be operative to cause an alarm, warning, or other information to be output via the HMI 192. For illustration, the processing system 20 may cause the at least one response parameter to be output via the HMI 192 for further use. Alternatively or additionally, the processing system 20 and/or the control system 180 may cause a frequency nadir or RoCoF predicted based on the at least one response parameter to be output via the HMI 192.

The system 10 comprises the control system 180. The processing system 20 may be operative to provide the at least one response parameter or information derived therefrom (such as a frequency nadir or RoCoF predicted based on the at least one response parameter for an expected further disturbance) to the control system 180.

The control system 180 may be operative to receive the at least one response parameter or information derived therefrom from the processing system 20 at a control system interface 181. The control system 180 may be operative to store the at least one response parameter or information derived therefrom in a control system storage 182.

The control system 180 may comprise one or several control circuits 183. The at least one control circuit 183 may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

The at least one control circuit 183 may be operative to perform a frequency change prediction 184 to determine one, several, or all of the following based on the at least one response parameter as well as information on a possible further disturbance: a prediction of a grid frequency evolution in response to the further disturbance; a prediction of the RoCoF in response to the further disturbance; a prediction of the frequency nadir in response to the further disturbance.

The at least one control circuit 183 may be operative to perform a power generator unit and/or load planning 185. The at least one control circuit 183 may be operative to adjust, for example, power generator unit commitment based on a result of the frequency change prediction 184. The at least one control circuit 183 may be operative to perform a control action acting on, e.g., at least on the power generation units, at least one rotating energy storage system, and/or at least one disconnector or circuit breaker in the power grid. The control action may be operative to reduce the change in grid frequency and/or maintain the grid frequency within a target frequency band. The control action may be selectively taken depending on the result of the frequency change prediction 184. The control action may be selected depending on the result of the frequency change prediction 184.

When the power grid has renewables penetration, the at least one control circuit 183 may be operative to determine adjusted settings for an energy management system (EMS) 193 and/or power management system (PMS) 194. The system 10 may comprise the EMS 193 and/or the PMS 194. The control system 180 may be operative to cause the adjusted settings to be used by the EMS 193 and/or the PMS 194 to mitigate the risk that the grid frequency leaves a target frequency band.

The at least one control circuit 183 may be operative to perform an HMI control 186. The at least one control circuit 183 may cause an alarm, warning, or other information that is based on the at least one response parameter to be output via the HMI 192.

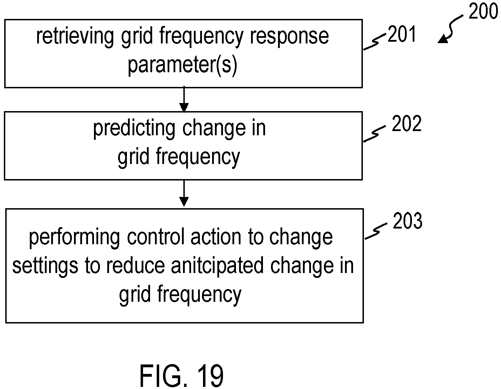

Figure 19 is a flow chart of a method 200. The method 200 may be performed automatically by the control system 180.

At process block 201, the control system 180 receives one or several response parameters that have been determined by the processing system 20. The control system 180 may receive the at least one response parameter the actively querying the processing system 20. The control system 180 may receive the at least one response parameter by a push process from the processing system 20.

At process block 202, the control system 180 predicts an expected forthcoming change in grid frequency that would be caused by a further disturbance. The prediction is based on the at least one response parameter and parameters of the further disturbance (such as magnitude, location, frequency, and/or duration). The prediction may optionally be based on forecast information, such as whether data, which may affect power generation by renewable power sources.

At process block 203, the control system 180 performs a control action in response to the prediction determined at process block 202. The control action may be performed selectively if required to ensure that the grid frequency stays within a target frequency band. The control action may be selected depending on a result of the prediction determined at process block 202. The control action may comprise one or several of: changing generator unit commitment; adjusting settings of an EMS; adjusting settings of a PMS.

Various effects and advantages are attained by the processing system, method, and system according to embodiments. The processing system and processing method allow at least one response parameter useful for predictively determining future grid frequency changes to be determined with enhanced accuracy. The processing system and processing method thereby allow control actions to be taken that are useful for maintaining the grid frequency within a desired frequency band.

While embodiments have been described in detail with reference to the drawings, various modifications may be implemented in other embodiments. For illustration rather than limitation:

- While embodiments have been described that are operative to determine at least an inertia of a generator equivalent model, the processing system and processing method may be operative to determine any one or any combination of the following parameters of the grid response: inertia, damping, governor time constant, governor gain, load sensitivity to voltage magnitude. The processing system and processing method may be operative to estimate any other parameters of grid frequency response and/or to perform the determination in an area-specific manner, e.g., by determining the inertia and optionally additional parameters in an area specific manner. The processing system and processing method may be operative to determine parameters (such as inertia) for a plurality equivalent generators per power grid or per area.
- While embodiments have been described in which the at least one response parameter is determined based on a generator equivalent model and a power swing equation, other formulations that link the time-dependent evolution of grid frequency to a time-dependent evolution of power may be used.

- While embodiments have been described in which the processing system is operative to approximately determine a change in load power based on a measurement of bus voltage magnitude, the techniques may be extended to other electric measurements that may be measured additionally or in the alternative. While techniques have been described in which the processing system assumes a linear relation between the change in bus voltage magnitude and the change in load power caused by the disturbance, more complex modeling techniques may be used, such as higher order dependencies, in which not only of on a proportionality factor but several parameters of a model that describes the dependency of the change in load power caused by the disturbance on the change in bus voltage magnitude and/or other electric measurements may be determined.
- While embodiments have been described in which the processing system is operative for approximately determine a change in loss power based on the output of a steady state estimator, other techniques of approximately determining the change in loss power may be used. For illustration, imputation techniques may be applied.
- While embodiments have been described in which the at least one response parameter is used to adjust generator unit commitment and/or to adjust settings of an EMS and/or PMS, the at least one response parameter may also be used for other purposes. For illustration, the at least one response parameter may be stored in an IED and used by a decision logic of the IED during field operation of the power grid.
- While embodiments have been described in which the disturbance source 13, the measurement instrumentation 12, the control system 14, 180, and the reactive power apparatus 153 are illustrated separately from the power grid 11, some or all of these components may also be integrated with the power grid.

Embodiments may be used in association with a power grid having renewables penetration, such as power grid comprising renewable energy systems (such as DERs), without being limited thereto.

This description and the accompanying drawings that illustrate aspects and embodiments of the present invention should not be taken as limiting-the claims defining the protected invention. In other words, while the invention has been illustrated and described in detail in the drawings and foregoing description, such illustration and description are to be considered illustrative and not restrictive. Various mechanical, compositional, structural, electrical, and operational changes may be made without departing from the spirit and scope of this description and the claims. In some instances, well-known circuits, structures and techniques have not been shown in detail in order not to obscure the invention. Thus, it will be understood that changes and modifications may be made by those of ordinary skill within the scope and spirit of the following claims. In particular, the present invention covers further embodiments with any combination of features from different embodiments described above and below.

The disclosure also covers all further features shown in the Figures individually although they may not have been described in the afore or following description. Also, single alternatives of the embodiments described in the Figures and the description and single alternatives of features thereof can be disclaimed from the subject matter of the invention or from disclosed subject matter. The disclosure comprises subject matter consisting of the features defined in the claims or the embodiments as well as subject matter comprising said features.

The term "comprising" does not exclude other elements or process blocks, and the indefinite article "a" or "an" does not exclude a plurality. A single unit or process block may fulfil the functions of several features recited in the claims. The mere fact that certain measures are recited in mutually different dependent claims does not indicate that a combination of these measures cannot be used to advantage. Components described as coupled or connected may be electrically or mechanically directly coupled, or they may be indirectly coupled via one or more intermediate components. Any reference signs in the claims should not be construed as limiting the scope.

A machine-readable instruction code may be stored/distributed on a suitable medium, such as an optical storage medium or a solid-state medium supplied together with or as part of other hardware, but may also be distributed in other forms, such as via a wide area network or other wired or wireless telecommunication systems. Furthermore, a machine-readable instruction code can also be a data structure product or a signal for embodying a specific method such as the method according to embodiments.

**Claims**

1.  A method of processing measurements acquired in a power grid (11), the method being performed by a processing system (20) and comprising:

    receiving data comprising frequency data, wherein the frequency data represent a grid frequency measured at one or several locations in the power grid (11) in response to a disturbance, and

    processing the received data to determine, for at least a part of the power grid (11), at least one response parameter that affects a grid frequency response of at least the part of the power grid (11) to a further disturbance, wherein the at least one response parameter is determined based on changes in power in response to the disturbance.

2.  The method of claim 1, wherein the changes in power comprise a total power deviation, wherein the total power deviation comprises a power of the disturbance and a change of load power and/or loss power caused by the disturbance.

3.  The method of claim 2, wherein processing the received data comprises determining the change of load power and/or loss power caused by the disturbance, optionally wherein processing the received data comprises determining the change of load power based on voltage magnitude measurements, and/or optionally wherein processing the received data comprises determining the change of load power and/or loss power based on a state estimation.

4.  The method of any one of the preceding claims, wherein processing the received data comprises determining the changes in power in a time-dependent manner, optionally wherein the changes in power are determined as time-series data or as non-regularly recurring data.

5.  The method of any one of the preceding claims, wherein the method comprises obtaining a disturbance magnitude and disturbance time information, optionally wherein the time information comprises an incipient time of the disturbance or a time series of at least one electric characteristic caused by the disturbance.

6.  The method of any one of the preceding claims, wherein the received data comprise outputs of measurement instrumentation (12), wherein the measurement instrumentation is coupled to the power grid (11).

7.  The method of any one of the preceding claims, further comprising causing the disturbance to be introduced into the power grid (11), optionally further comprising setting a disturbance frequency of the disturbance based on electric and/or mechanical resonances of the power grid (11), further optionally wherein the disturbance frequency is set to prevent excitation of the electric and/or mechanical resonances of the power grid (11).

8.  The method of claim 7, wherein causing the disturbance to be introduced into the power grid (11) comprises controlling at least one apparatus (13, 153) comprised by or coupled to the power grid (11) to introduce the disturbance and reduce an impact of the disturbance on voltage magnitudes in the power grid (11), optionally wherein the at least one apparatus comprises an apparatus operative to affect reactive power in the power grid (11).

9.  The method of any one of the preceding claims,

    wherein the at least one response parameter comprises a parameter of a generator equivalent model, optionally wherein the at least one response parameter comprises a parameter of a single generator equivalent model of generators of the power grid (11) or of part of the power grid (11), and/or optionally wherein the determined response parameter comprises one, several, or all of: inertia, damping, governor time constant, governor gain, load sensitivity to voltage magnitude; and/or

wherein the at least one response parameter comprises an inertia of a generator equivalent of one or several power generators of the power grid.

10. The method of any one of the preceding claims, further comprising repeating the steps of receiving data and processing the received data for two or more areas of the power grid (11) to determine the at least one response parameter for each of the two or more areas,

optionally where the changes in power are determined further based on tie-line power flows in and out of the respective areas.

11. The method of any one of the preceding claims, further comprising

storing the at least one response parameter in a control, monitoring, and/or protection device or system (180) for assessing the grid frequency response to the further disturbance, and/or

using, by the processing system (20), the at least one response parameter to assess the grid frequency response to the further disturbance, optionally wherein the assessed grid frequency response comprises a rate of change of frequency, RoCoF, and/or a frequency nadir.

12. The method of any one of the preceding claims, further comprising effecting, by the processing system (20) or a control, monitoring, and/or protection device or system (180), an action based on the at least one response parameter, optionally wherein the action comprises a corrective and/or mitigating action that reduces a change in grid frequency brought about by the further disturbance.

13. A power grid control, monitoring, and/or protection method, comprising:

using, by a control, monitoring, and/or protection device or system (180), the at least one response parameter determined by the method of any one of the preceding claims to determine the at least one response parameter, and

performing an action based on the at least one response parameter to reduce a change in grid frequency brought about by the further disturbance.

14. A processing system (20) for processing measurements acquired in a power grid (11), the processing system (20) comprising at least one processing circuit operative to:

receive data comprising frequency data, wherein the frequency data represent a grid frequency measured at one or several locations in the power grid (11) in response to a disturbance, and

process the received data to determine, for at least a part of the power grid (11), at least one response parameter that affects a grid frequency response of at least the part of the power grid (11) to a further disturbance, wherein the at least one processing circuit is operative to determine the at least one response parameter based on changes in power in response to the disturbance.

15. A system, comprising:

a power grid (11);

the processing system (20) of claim 14 operative to determine the at least one response parameter; and

a control, monitoring, and/or protection device or system (180) operative to perform an action in response to the further disturbance based on the at least one response parameter.

storage system

frequency & disturbance
data processing

response parameter
determination

action based
on response parameter

processing circuit(s)

processing system

interface

output interface

FIG. 1

FIG. 2

30

disturbance power
determination

31

34

loss power
deviation determination

35

load power
deviation determination

36

response parameter
determination

32

action based
on response parameter

33

processing circuit(s)

FIG. 3

FIG. 4

FIG. 5

FIG. 6

FIG. 7

```
receiving data comprising          ⟋ 91        ⟋ 90
frequency data

obtaining disturbance magnitude    ⟋ 92
and disturbance timing information

determining grid frequency response ⟋ 93
parameter(s)

providing grid frequency response  ⟋ 94
parameter(s) for use
```

FIG. 8

determining change in power in
time window after disturbance ⟋101    ⟋100

↓

determining change in grid frequency
in time window after disturbance ⟋102

↓

using time-dependent change in grid
frequency and change in power
to determine grid frequency response
parameter(s) ⟋103

## FIG. 9

determining disturbance power as
function of time ⟋111    ⟋110

↓

determining change in load and/or
loss power caused by disturbance
as function of time ⟋112

## FIG. 10

obtaining voltage measurements ⟋121    ⟋120

↓

estimating change in load power caused
by disturbance from voltage
measurements ⟋122

## FIG. 11

130

selecting candidate
proportionality factor — 131

↓

performing optimization routine to
find parameters of parametric equation — 132

↓

determining metric quantifying
difference between measured change in
grid frequency and curve obtained
for the found parameters — 133

↓

YES ◁ other candidate
proportionality factor
left? — 134

↓ NO

selecting proportionality factor that
optimizes the metric — 135

## FIG. 12

Δf [arb. units]

142

143

141

time [arb. units]

## FIG. 13

FIG. 12

time [arb. units]

FIG. 13

FIG. 14

FIG. 15

10

| disturbance source | → | power grid | → | measurement instrument(s) |

13    11    12

reactive power

153

processing system

152

counter-measure controller

disturbance source controller

151    20

inertia

15

control system

14

FIG. 16

receiving electrical disturbance and frequency data — 171

receiving additional power grid data (optional) — 172

signal preprocessing (optional) — 173

inertia estimation — 174

using inertia estimate — 175

170

FIG. 17

191

192

20

10

190

control system
interface — 181

control system
storage — 182

frequency change
prediction — 184

power generation unit
and/or load planning — 185

HMI
control — 186

control circuit(s)

183

control system — 180

EMS — 193

PMS — 194

FIG. 18

```
                                                                    ⟋ 200
┌─────────────────────────────────┐   ⟋ 201      ⬐
│   retrieving grid frequency response   │
│         parameter(s)                   │
└─────────────────────────────────┘
                 │
                 ▼
┌─────────────────────────────────┐   ⟋ 202
│      predicting change in              │
│         grid frequency                 │
└─────────────────────────────────┘
                 │
                 ▼
┌─────────────────────────────────┐   ⟋ 203
│   performing control action to change  │
│  settings to reduce anitcipated change in │
│            grid frequency              │
└─────────────────────────────────┘
```

# FIG. 19

# EP 4 429 059 A1

Europäisches
Patentamt

European
Patent Office

Office européen
des brevets

## EUROPEAN SEARCH REPORT

Application Number

EP 23 16 0075

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KERDPHOL THONGCHART ET AL: "Determining Inertia of 60 Hz Japan Power System using PMUs from Power Loss Event", 2021 IEEE TEXAS POWER AND ENERGY CONFERENCE (TPEC), IEEE, 2 February 2021 (2021-02-02), pages 1-5, XP033893515, DOI: 10.1109/TPEC51183.2021.9384932 [retrieved on 2021-03-23] * the whole document * | 1-7,9-15 | INV.<br>H02J3/24<br>G01R19/25<br>G01R21/133<br>G06Q50/06 |
| X | RABUZIN TIN ET AL: "Computation of sensitivity-based islanding detection parameters for synchronous generators", ELECTRIC POWER SYSTEMS RESEARCH, ELSEVIER, AMSTERDAM, NL, vol. 190, 4 August 2020 (2020-08-04), XP086360031, ISSN: 0378-7796, DOI: 10.1016/J.EPSR.2020.106611 [retrieved on 2020-08-04] * the whole document * | 1,7,8, 13-15 | |

TECHNICAL FIELDS
SEARCHED        (IPC)

H02J

The present search report has been drawn up for all claims

| Place of search | Date of completion of the search | Examiner |
|---|---|---|
| Munich | 18 August 2023 | Hartmann, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

47

**REFERENCES CITED IN THE DESCRIPTION**

**Patent documents cited in the description**

- US 10218181 B2
- US 10997674 B2
- US 11112438 B2